# EUROPEAN PATENT APPLICATION

(11) **EP 4 651 692 A1**
(43) Date of publication of application: **19.11.2025**
(21) Application number: 24795699.8
(22) Date of filing: 19.03.2024
(51) Int. Cl.: H10K 59/131

(54) **DISPLAY PANEL AND DISPLAY DEVICE**

(30) Priority: 25.04.2023 CN 202310456499
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: LIU, Cong, Beijing 100176 (CN); ZHAO, Erjin, Beijing 100176 (CN); SONG, Gukhwan, Beijing 100176 (CN); JIANG, Zhiliang, Beijing 100176 (CN)
(74) Representative: CMS Cameron McKenna Nabarro Olswang LLP
(86) International application number: PCT/CN2024/082370
(87) International publication number: WO 2024/222316

(57) **Abstract**

A display panel, comprising: a substrate, a plurality of sub-pixels, a plurality of data lines, a plurality of multiplexing circuits, a plurality of multiplexing data lines, and N multiplexing control lines. The plurality of multiplexing circuits, the plurality of multiplexing data lines, and the N multiplexing control lines are located in a first frame region on at least one side of a display region. N is equal to 2n+1, and n is an integer greater than 0. At least one multiplexing circuit is electrically connected to the N multiplexing control lines, a multiplexing data line, and a plurality of data lines, and is configured to, under the control of the N multiplexing control lines, provide to the plurality of data lines a data signal transmitted by the multiplexing data line. The orthographic projections of each multiplexing data line and at least n multiplexing control lines on the substrate overlap, or the orthographic projections of the plurality of multiplexing data lines and the N multiplexing control lines on the substrate do not overlap.

## Description

The present application claims priority to Chinese Patent Application No. 202310456499.6, filed to the CNIPA on April 25, 2023 and entitled "Display Panel and Display Device", contents of which should be construed as being incorporated into the present application by reference.

### Technical Field

The present disclosure relates to, but is not limited to, the field of display technologies, in particular to a display panel and a display apparatus.

### Background

An Organic light emitting Diode (OLED) is an active light emitting display device and has advantages such as self-luminescence, a wide viewing angle, a high contrast ratio, low power consumption, an extremely high response speed, etc. With continuous development of display technologies, a display apparatus in which an OLED is used as a light emitting device and signal control is performed by a Thin Film Transistor (TFT) has become a mainstream product in the field of display at present.

### Summary

The following is a summary of subject matters described herein in detail. This summary is not intended to limit the protection scope of claims.

Embodiments of the present disclosure provide a display panel and a display apparatus.

In one aspect, an embodiment provides a display panel including a base substrate, a plurality of sub-pixels, a plurality of data lines, a plurality of multiplexing circuits, a plurality of multiplexing data lines, and N multiplexing control lines. The base substrate includes a display region and a first bezel region located on at least one side of the display region. The plurality of sub-pixels and the plurality of data lines are located in the display region, wherein the plurality of data lines are connected with the plurality of sub-pixels and configured to provide data signals to the plurality of sub-pixels. The plurality of multiplexing circuits, the plurality of multiplexing data lines, and the N multiplexing control lines are located in the first bezel region, wherein N is equal to 2n+1, and n is an integer greater than 0. At least one multiplexing circuit of the plurality of multiplexing circuits is electrically connected with the N multiplexing control lines, one multiplexing data line, and a plurality of data lines, and is configured to provide a data signal transmitted by the multiplexing data line to the plurality of data lines under control of the N multiplexing control lines. An orthographic projection of each multiplexing data line of the plurality of multiplexing data lines on the base substrate is overlapped with orthographic projections of at least n multiplexing control lines on the base substrate, or orthographic projections of the plurality of multiplexing data lines on the base substrate are not overlapped with orthographic projections of the N multiplexing control lines on the base substrate.

In some exemplary implementation modes, the N multiplexing control lines include a first set of multiplexing control lines and a second set of multiplexing control lines, wherein the first set of multiplexing control lines includes n multiplexing control lines and the second set of multiplexing control lines includes n+1 multiplexing control lines. The plurality of multiplexing data lines include a first set of multiplexing data lines and a second set of multiplexing data lines, wherein an orthographic projection of each multiplexing data line in the first set of multiplexing data lines on the base substrate is overlapped with orthographic projections of n multiplexing control lines in the first set of multiplexing control lines on the base substrate, and each multiplexing data line in the second set of multiplexing data lines is overlapped with n+1 multiplexing control lines in the second set of multiplexing control lines.

In some exemplary implementation modes, the plurality of sub-pixels include: a first sub-pixel emitting light of a first color, a second sub-pixel emitting light of a second color, and a third sub-pixel emitting light of a third color; at least one of the N multiplexing control lines is configured to control the multiplexing circuit to provide data signals to a plurality of first sub-pixels through the data lines, at least one of the N multiplexing control lines is configured to control the multiplexing circuit to provide data signals to a plurality of second sub-pixels through the data lines, and at least one of the N multiplexing control lines is configured to control the multiplexing circuit to provide data signals to a plurality of third sub-pixels through the data lines.

In some exemplary implementation modes, a value of n is 4.

In some exemplary implementation modes, the N multiplexing control lines include a first multiplexing control line, a second multiplexing control line, a third multiplexing control line, a fourth multiplexing control line, a fifth multiplexing control line, a sixth multiplexing control line, a seventh multiplexing control line, an eighth multiplexing control line, and a ninth multiplexing control line. The plurality of sub-pixels include a first set of sub-pixels, a second set of sub-pixels, and a third set of sub-pixels, wherein the first set of sub-pixels includes a first set of first sub-pixels, a first set of second sub-pixels, and a first set of third sub-pixels, the second set of sub-pixels includes a second set of first sub-pixels, a second set of second sub-pixels, and a second set of third sub-pixels, and the third set of sub-pixels includes a third set of first sub-pixels, a third set of second sub-pixels, and a third set of third sub-pixels. The first multiplexing control line is configured to control the multiplexing circuit to provide data signals to the first set of first sub-pixels; the second multiplexing control line is configured to control the multiplexing circuit to provide data signals to the first set of second sub-pixels; the third multiplexing control line is configured to control the multiplexing circuit to provide data signals to the first set of third sub-pixels; the fourth multiplexing control line is configured to control the multiplexing circuit to provide data signals to the second set of first sub-pixels; the fifth multiplexing control line is configured to control the multiplexing circuit to provide data signals to the second set of second sub-pixels; the sixth multiplexing control line is configured to control the multiplexing circuit to provide data signals to the second set of third sub-pixels; the seventh multiplexing control line is configured to control the multiplexing circuit to provide data signals to the third set of first sub-pixels; the eighth multiplexing control line is configured to control the multiplexing circuit to provide data signals to the third set of second sub-pixels; and the ninth multiplexing control line is configured to control the multiplexing circuit to provide data signals to the third set of third sub-pixels. The first set of multiplexing control lines includes a fourth multiplexing control line, a seventh multiplexing control line, an eighth multiplexing control line, and a ninth multiplexing control line; and the second set of multiplexing control lines includes a first multiplexing control line, a second multiplexing control line, a third multiplexing control line, a sixth multiplexing control line, and a fifth multiplexing control line.

In some exemplary implementation modes, in the first set of multiplexing control lines, the fourth multiplexing control line, the seventh multiplexing control line, the eighth multiplexing control line, and the ninth multiplexing control line are sequentially arranged along a direction away from the second set of multiplexing data lines. In the second set of multiplexing control lines, the first multiplexing control line, the second multiplexing control line, the third multiplexing control line, the sixth multiplexing control line, and the fifth multiplexing control line are sequentially arranged along a direction away from the first set of multiplexing data lines.

In some exemplary implementation modes, in the N multiplexing control lines, a multiplexing control line for controlling the multiplexing circuit to provide data signals to the first sub-pixels is a first-type multiplexing control line, a multiplexing control line for controlling the multiplexing circuit to provide data signals to the second sub-pixels is a second-type multiplexing control line, and a multiplexing control line for controlling the multiplexing circuit to provide data signals to the third sub-pixels is a third-type multiplexing control line. The first set of multiplexing control lines includes: the first-type multiplexing control line and at least one third-type multiplexing control line; and the second set of multiplexing control lines includes the third-type multiplexing control line and remaining third-type multiplexing control lines.

In some exemplary implementation modes, the N multiplexing control lines include a first multiplexing control line, a second multiplexing control line, a third multiplexing control line, a fourth multiplexing control line, a fifth multiplexing control line, a sixth multiplexing control line, a seventh multiplexing control line, an eighth multiplexing control line, and a ninth multiplexing control line. The plurality of sub-pixels include a first set of sub-pixels, a second set of sub-pixels, and a third set of sub-pixels, wherein the first set of sub-pixels includes a first set of first sub-pixels, a first set of second sub-pixels, and a first set of third sub-pixels, the second set of sub-pixels includes a second set of first sub-pixels, a second set of second sub-pixels, and a second set of third sub-pixels, and the third set of sub-pixels includes a third set of first sub-pixels, a third set of second sub-pixels, and a third set of third sub-pixels. The first multiplexing control line is configured to control the multiplexing circuit to provide data signals to the first set of first sub-pixels; the second multiplexing control line is configured to control the multiplexing circuit to provide data signals to the first set of second sub-pixels; the third multiplexing control line is configured to control the multiplexing circuit to provide data signals to the first set of third sub-pixels; the fourth multiplexing control line is configured to control the multiplexing circuit to provide data signals to the second set of first sub-pixels; the fifth multiplexing control line is configured to control the multiplexing circuit to provide data signals to the second set of second sub-pixels; the sixth multiplexing control line is configured to control the multiplexing circuit to provide data signals to the second set of third sub-pixels; the seventh multiplexing control line is configured to control the multiplexing circuit to provide data signals to the third set of first sub-pixels; the eighth multiplexing control line is configured to control the multiplexing circuit to provide data signals to the third set of second sub-pixels; and the ninth multiplexing control line is configured to control the multiplexing circuit to provide data signals to the third set of third sub-pixels. The first set of multiplexing control lines includes a first multiplexing control line, a fourth multiplexing control line, a seventh multiplexing control line, and a third multiplexing control line; and the second set of multiplexing control lines includes a second multiplexing control line, a fifth multiplexing control line, an eighth multiplexing control line, a sixth multiplexing control line, and a ninth multiplexing control line.

In some exemplary implementation modes, the plurality of multiplexing data lines include a first set of multiplexing data lines and a second set of multiplexing data lines, and a quantity of multiplexing control lines overlapped with each multiplexing data line of the first set of multiplexing data lines is the same as a quantity of multiplexing control lines overlapped with each multiplexing data line of the second set of multiplexing data lines.

In some exemplary implementation modes, the N multiplexing control lines include a first set of multiplexing control lines and a second set of multiplexing control lines, wherein the first set of multiplexing control lines includes n multiplexing control lines, and the second set of multiplexing control lines includes n+1 multiplexing control lines. An orthographic projection of each multiplexing data line in the first set of multiplexing data lines on the base substrate is overlapped with orthographic projections of n multiplexing control lines in the first set of multiplexing control lines and an extension line of one multiplexing control line in the second set of multiplexing control lines on the base substrate, and an orthographic projection of each multiplexing data line in the second set of multiplexing data lines on the base substrate is overlapped with orthographic projections of n+1 multiplexing control lines in the second set of multiplexing control lines on the base substrate.

In some exemplary implementation modes, the plurality of sub-pixels include a first sub-pixel emitting light of a first color, a second sub-pixel emitting light of a second color, and a third sub-pixel emitting light of a third color. A multiplexing control line having an extension line in the second set of multiplexing control lines is configured to control the multiplexing circuit to provide a data signal to the third sub-pixel.

In some exemplary implementation modes, the N multiplexing control lines include a first multiplexing control line, a second multiplexing control line, a third multiplexing control line, a fourth multiplexing control line, a fifth multiplexing control line, a sixth multiplexing control line, a seventh multiplexing control line, an eighth multiplexing control line, and a ninth multiplexing control line. The plurality of sub-pixels include a first set of sub-pixels, a second set of sub-pixels, and a third set of sub-pixels, wherein the first set of sub-pixels includes a first set of first sub-pixels, a first set of second sub-pixels, and a first set of third sub-pixels, the second set of sub-pixels includes a second set of first sub-pixels, a second set of second sub-pixels, and a second set of third sub-pixels, and the third set of sub-pixels includes a third set of first sub-pixels, a third set of second sub-pixels, and a third set of third sub-pixels. The first multiplexing control line is configured to control the multiplexing circuit to provide data signals to the first set of first sub-pixels; the second multiplexing control line is configured to control the multiplexing circuit to provide data signals to the first set of second sub-pixels; the third multiplexing control line is configured to control the multiplexing circuit to provide data signals to the first set of third sub-pixels; the fourth multiplexing control line is configured to control the multiplexing circuit to provide data signals to the second set of first sub-pixels; the fifth multiplexing control line is configured to control the multiplexing circuit to provide data signals to the second set of second sub-pixels; the sixth multiplexing control line is configured to control the multiplexing circuit to provide data signals to the second set of third sub-pixels; the seventh multiplexing control line is configured to control the multiplexing circuit to provide data signals to the third set of first sub-pixels; the eighth multiplexing control line is configured to control the multiplexing circuit to provide data signals to the third set of second sub-pixels; and the ninth multiplexing control line is configured to control the multiplexing circuit to provide data signals to the third set of third sub-pixels. The first set of multiplexing control lines includes: a sixth multiplexing control line, a seventh multiplexing control line, an eighth multiplexing control line, and a ninth multiplexing control line; and the second set of multiplexing control lines includes: a first multiplexing control line, a second multiplexing control line, a third multiplexing control line, a fourth multiplexing control line, and a fifth multiplexing control line; wherein the third multiplexing control line has an extension line.

In some exemplary implementation modes, an orthographic projection of each multiplexing data line of the first set of multiplexing data lines and the second set of multiplexing data lines on the base substrate is overlapped with orthographic projections of the N multiplexing control lines on the base substrate.

In some exemplary implementation modes, each of the N multiplexing control lines has an extension line; the N multiplexing control lines include a first set of multiplexing control lines and a second set of multiplexing control lines, wherein the first set of multiplexing control lines includes n multiplexing control lines, and the second set of multiplexing control lines includes n+1 multiplexing control lines. An orthographic projection of each multiplexing data line in the first set of multiplexing data lines on the base substrate is overlapped with orthographic projections of extension lines of n multiplexing control lines in the first set of multiplexing control lines and n+1 multiplexing control lines in the second set of multiplexing control lines on the base substrate, and an orthographic projection of each multiplexing data line in the second set of multiplexing data lines on the base substrate is overlapped with orthographic projections of extension lines of n+1 multiplexing control lines in the second set of multiplexing control lines and n multiplexing control lines in the first set of multiplexing control lines on the base substrate.

In some exemplary implementation modes, the light of the first color is red light, the light of the second color is green light, and the light of the third color is blue light.

In some exemplary implementation modes, the first bezel region includes at least a first signal access region and a second signal access region, and the second signal access region is located on a side of the first signal access region away from the display region; the first signal access region is provided with a first set of first contact pads; the second signal access region is provided with a plurality of multiplexing control contact pads; and the plurality of multiplexing data lines are connected with a first set of first contact pads in the first signal access region, and the N multiplexing control lines are connected with a plurality of multiplexing control contact pads in the second signal access region.

In some exemplary implementation modes, the first signal access region is further provided with a second set of first contact pads, and the second set of first contact pads is located on a side of the first set of first contact pads away from the display region; the second signal access region is further provided with a set of middle contact pads; and the second set of first contact pads in the first signal access region is connected with the set of middle contact pads in the second signal access region through a plurality of pin connection lines. The plurality of multiplexing control contact pads in the second signal access region include a first set of multiplexing control contact pads and a second set of multiplexing control contact pads, and the first set of multiplexing control contact pads and the second set of multiplexing control contact pads are located on opposite sides of the set of middle contact pads along a first direction.

In some exemplary implementation modes, the first set of multiplexing control lines is connected with the first set of multiplexing control contact pads, and the second set of multiplexing control lines is connected with the second set of multiplexing control contact pads.

In some exemplary implementation modes, a first end of each multiplexing control line in the N multiplexing control lines is connected with the first set of multiplexing control contact pads, and a second end of each multiplexing control line is connected with the second set of multiplexing control contact pads.

In some exemplary implementation modes, orthographic projections of the plurality of multiplexing data lines on the base substrate are not overlapped with orthographic projections of the N multiplexing control lines on the base substrate, and the N multiplexing control lines include a first set of multiplexing control lines and a second set of multiplexing control lines, wherein the first set of multiplexing control lines includes n multiplexing control lines and the second set of multiplexing control lines includes n+1 multiplexing control lines; and the first set of multiplexing control lines and the second set of multiplexing control lines are disposed on opposite sides of the plurality of multiplexing data lines. In another aspect, an embodiment of the present disclosure provides a display apparatus, which includes the aforementioned display panel.

In another aspect, an embodiment provides a display panel including a base substrate, a plurality of sub-pixels, a plurality of data lines, a plurality of multiplexing circuits, a plurality of multiplexing data lines, and N multiplexing control lines. The base substrate includes a display region and a first bezel region located on at least one side of the display region. The plurality of sub-pixels and the plurality of data lines are located in the display region, wherein the plurality of data lines are connected with the plurality of sub-pixels and configured to provide data signals to the plurality of sub-pixels. The plurality of multiplexing circuits, the plurality of multiplexing data lines, and the N multiplexing control lines are located in the first bezel region, wherein N is equal to 2n+1, and n is an integer greater than 0. At least one multiplexing circuit of the plurality of multiplexing circuits is electrically connected with the N multiplexing control lines, one multiplexing data line, and a plurality of data lines, and is configured to provide a data signal transmitted by the multiplexing data line to the plurality of data lines under control of the N multiplexing control lines. At least part of line segments of each multiplexing data line of the plurality of multiplexing data lines extend along a first direction and at least part of line segments of each multiplexing control line of the N multiplexing control lines extend along a second direction; and at least part of line segments of the multiplexing data line intersect with at least part of line segments of the multiplexing control line.

In some exemplary implementation modes, at least part of line segments of the multiplexing control line and at least part of line segments of the plurality of multiplexing data lines have a same intersection angle.

In some exemplary implementation modes, an intersection angle between at least part of line segments of the multiplexing control line and at least part of line segments of the multiplexing data line is less than or equal to 90 degrees.

In some exemplary implementation modes, a value of N is 9.

Other aspects of the present disclosure may be comprehended after drawings and detailed description are read and understood.

### Brief Description of Drawings

Accompanying drawings are used for providing further understanding of technical solutions of the present disclosure, constitute part of the specification, and are used for explaining the technical solutions of the present disclosure together with the embodiments of the present disclosure, but do not constitute limitations on the technical solutions of the present disclosure. Shapes and sizes of one or more components in the drawings do not reflect actual scales, but are only intended to schematically describe contents of the present disclosure.
FIG. 1 is a schematic diagram of a display panel according to at least one embodiment of the present disclosure.
FIG. 2 is a schematic partial cross-sectional view of a display region of a display panel according to at least one embodiment of the present disclosure.
FIG. 3 is a schematic partial plan view of a first bezel region according to at least one embodiment of the present disclosure.
FIG. 4 is an equivalent circuit diagram of a multiplexing circuit according to at least one embodiment of the present disclosure.
FIG. 5 is an exemplary diagram of an arrangement of a multiplexing control line and a multiplexing data line according to at least one embodiment of the present disclosure.
FIG. 6 is a partially enlarged schematic diagram of a region S1 in FIG. 3.
FIG. 7 is a partially enlarged schematic diagram of a region S2 in FIG. 3.
FIG. 8A is a schematic diagram of a display panel after a first gate metal layer is formed in FIG. 7.
FIG. 8B is a schematic diagram of a display panel after a second gate metal layer is formed in FIG. 7.
FIG. 8C is a schematic diagram of a display panel after a first source-drain metal layer is formed in FIG. 7.
FIG. 9 is a partially enlarged schematic diagram of a region S3 in FIG. 3.
FIG. 10 is a partially enlarged schematic diagram of a region S4 in FIG. 3.
FIG. 11 is an exemplary diagram of another arrangement of a multiplexing control line and a multiplexing data line according to at least one embodiment of the present disclosure.
FIG. 12 is an exemplary diagram of another arrangement of a multiplexing control line and a multiplexing data line according to at least one embodiment of the present disclosure.
FIG. 13 is an exemplary diagram of another arrangement of a multiplexing control line and a multiplexing data line according to at least one embodiment of the present disclosure.
FIG. 14 is an exemplary diagram of another arrangement of a multiplexing control line and a multiplexing data line according to at least one embodiment of the present disclosure.
FIG. 15 is an exemplary diagram of another arrangement of a multiplexing control line and a multiplexing data line according to at least one embodiment of the present disclosure.
FIG. 16 is a schematic diagram of a display apparatus according to at least one embodiment of the present disclosure.

### Detailed Description

The embodiments of the present disclosure will be described below with reference to the drawings in detail. Implementation modes may be implemented in a plurality of different forms. Those of ordinary skills in the art may easily understand such a fact that modes and contents may be transformed into various forms without departing from the purpose and scope of the present disclosure. Therefore, the present disclosure should not be explained as being limited to contents recorded in following implementation modes only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one mode of the present disclosure is not necessarily limited to the size, and a shape and a size of one or more components in the drawings do not reflect an actual scale. In addition, the accompanying drawings schematically illustrate ideal examples, and one mode of the present disclosure is not limited to shapes, numerical values, or the like shown in the drawings.

Ordinal numerals "first", "second", "third", etc., in the specification are set not to form limits in numbers but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside", etc., for indicating directional or positional relationships are used to illustrate positional relationships between the constituent elements with reference to the accompanying drawings, not to indicate or imply that a referred apparatus or element must have a specific orientation or be structured and operated in the specific orientation but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art may understand meanings of the aforementioned terms in the present disclosure according to situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. In the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification.

In the specification, a "connection" includes a case where constituent elements are connected together through an element with a certain electrical action. The "element with a certain electrical action" is not particularly limited as long as electrical signals between the connected constituent elements may be transmitted. Examples of the "element with a certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is above -10 °and below 10 °, and thus may include a state in which the angle is above -5 ° and below 5°. In addition, "perpendicular" refers to a state in which an angle formed by two straight lines is above 80 °and below 100 °, and thus may include a state in which the angle is above 85 °and below 95 °.

In the present disclosure, "about" and "substantially" refer to that a boundary is not defined strictly and a case within a range of process and measurement errors is allowed.

In the present specification, "A extends along a B direction" means that A may include a main portion and a secondary portion connected with the main portion, the main portion is a line, a line segment, or a strip-shaped body, the main portion extends along the B direction, and a length of the main portion extending along the B direction is greater than a length of the secondary portion extending along another direction. "A extends along a B direction" mentioned in the present specification always means "a main portion of A extends along a B direction".

"A and B are of a same layer structure" mentioned in the present specification means that A and B are formed simultaneously through a same patterning process. A "same layer" does not always mean that thicknesses of layers or heights of layers are the same in a section diagram. "An orthographic projection of A contains an orthographic projection of B" means that the orthographic projection of B falls within a range of the orthographic projection of A, or the orthographic projection of A covers the orthographic projection of B.

With development of display technologies, increasing a screen-to-body ratio and reducing a bezel size is an important direction of improvement. A current display panel is usually provided with a multiplexing circuit (MUX) to reduce a quantity of data lines, thereby reducing space where a data fanout line in a bezel region is located to reduce a bezel size. However, there is a case where there is overlap in an arrangement of traces connected with the multiplexing circuit in the bezel region, and a capacitance generated by overlapping of the traces affects signals transmitted by the traces to generate a load difference (for example, a load difference of data signals or a load difference of multiplexing control signals), thereby causing poor display of the display panel. Taking a case that the display panel is applied to a wearable product such as a watch as an example, the multiplexing circuit is very important to image quality of the wearable product such as the watch. Especially when low gray-scale display is performed, a signal load difference caused by overlapping of traces connected with the multiplexing circuit will lead to poor display such as bright and dark stripes or split screen.

The embodiments provide a display panel and a display apparatus, which may improve a situation of poor display led by a signal load difference caused by overlapping of traces connected with a multiplexing circuit.

An embodiment provides a display panel, including a base substrate, a plurality of sub-pixels, a plurality of data lines, a plurality of multiplexing circuits, a plurality of multiplexing data lines, and N multiplexing control lines. The base substrate includes a display region and a first bezel region located on at least one side of the display region. The plurality of sub-pixels and the plurality of data lines are located in the display region, and the plurality of data lines are connected with the plurality of sub-pixels and configured to provide data signals to the plurality of sub-pixels. The plurality of multiplexing circuits, the plurality of multiplexing data lines, and the N multiplexing control lines are located in the first bezel region. N is equal to 2n+1, and n is an integer greater than 0. At least one multiplexing circuit among the plurality of multiplexing circuits is electrically connected with the N multiplexing control lines, one multiplexing data line, and a plurality of data lines, and is configured to provide a data signal transmitted by the multiplexing data line to the plurality of data lines under control of the N multiplexing control lines. An orthographic projection of each multiplexing data line among the plurality of multiplexing data lines on the base substrate is overlapped with orthographic projections of at least n multiplexing control lines on the base substrate, or orthographic projections of the plurality of multiplexing data lines on the base substrate are not overlapped with orthographic projections of the N multiplexing control lines on the base substrate. In this example, a quantity of multiplexing control lines may be an odd number. For example, a value of n may be 4, and a value of N may be 9.

In the display panel according to the present embodiment, by disposing that an orthographic projection of each multiplexing data line among the plurality of multiplexing data lines on the base substrate are overlapped with orthographic projections of at least n multiplexing control lines on the base substrate, or orthographic projections of the plurality of multiplexing data lines on the base substrate are not overlapped with orthographic projections of the N multiplexing control lines on the base substrate, it is possible to avoid or greatly reduce a signal load difference caused by overlapping of traces between the multiplexing data lines and the multiplexing control lines connected with the multiplexing circuit, thereby improving poor display of the display panel.

Solutions of the present embodiment will be described below through a plurality of examples.

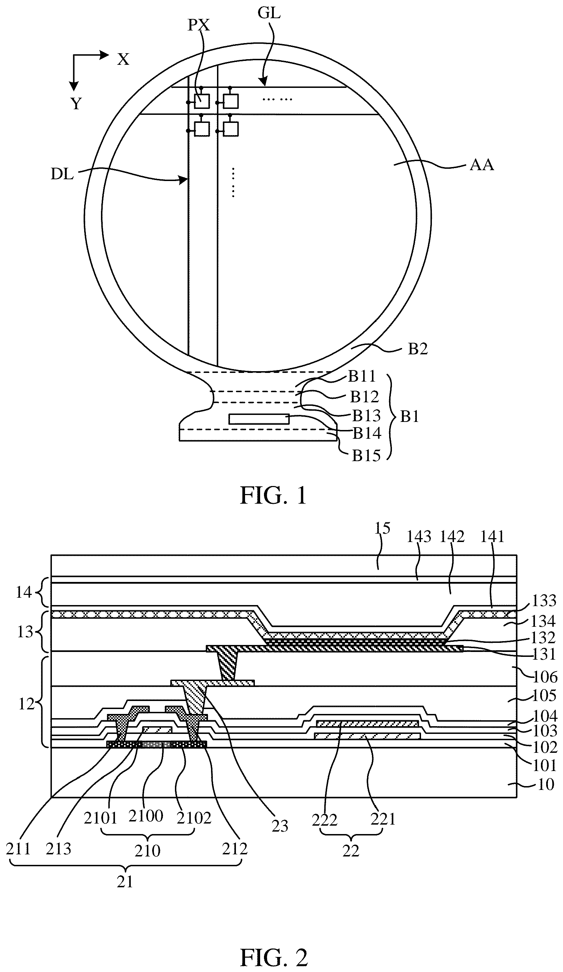

FIG. 1 is a schematic diagram of a display panel according to at least one embodiment of the present disclosure. In some examples, as shown in FIG. 1, the display panel may include a display region AA, a first bezel region B1 located on a side of the display region AA, and a second bezel region B2 located on a remaining side of the display region AA. The first bezel region B1 may be communicated with the second bezel region B2. For example, the first bezel region B1 may be a lower bezel of the display panel, and the second bezel region B2 may include remaining bezel regions of the display panel other than the lower bezel.

In some examples, as shown in FIG. 1, the display region AA may be a planar region including a plurality of sub-pixels PX forming a pixel array, the plurality of sub-pixels PX may be configured to display a dynamic picture or a static image. The display region AA may be referred to as an active region (Active Area). In some examples, the display region AA may be in a shape of a circle or an oval. However, the present embodiment is not limited thereto. For example, the display region may be in another shape such as a shape of a rectangle. In some examples, the display panel may be a flexible panel, and accordingly the display panel may be deformable, for example, may be crimped, bent, folded, or curled.

In some examples, as shown in FIG. 1, the display region AA may include a display structure layer disposed on a base substrate, or may include a display structure layer and a touch structure layer disposed sequentially on the base substrate. For example, in the display panel, a touch structure may be integrated to form a Touch on Thin film Encapsulation (Touch on TFE for short) structure. The Touch on TFE structure mainly includes a Flexible Multi-Layer On Cell (FMLOC) structure and a Flexible Single-Layer On Cell (FSLOC) structure. The FMLOC structure is based on a working principle of mutual capacitance detection. Generally, a drive (Tx) electrode and a sensing (Rx) electrode are formed by using two layers of metal, and a drive chip (Integrated Circuit (IC)) achieves a touch action by detecting a mutual capacitance between the drive electrode and the sensing electrode. The FSLOC structure is based on a working principle of self-capacitance (or voltage) detection. Generally, a touch electrode is formed by using a single layer of metal, and an integrated circuit achieves a touch action by detecting a self-capacitance (or voltage) of the touch electrode.

In some examples, the display structure layer may include a plurality of sub-pixels PX, a plurality of gate lines GL, and a plurality of data lines DL. The plurality of gate lines GL may extend along a first direction X, and the plurality of data lines DL may extend along a second direction Y. Orthographic projections of the plurality of gate lines GL on the base substrate may intersect with orthographic projections of the plurality of data lines DL on the base substrate, thereby forming a plurality of sub-pixel regions. One sub-pixel PX may be disposed within one sub-pixel region. The plurality of data lines DL may be electrically connected with the plurality of sub-pixels PX and the plurality of data lines DL may be configured to provide data signals to the plurality of sub-pixels PX. The plurality of gate lines GL may be electrically connected with the plurality of sub-pixels PX and the plurality of gate lines GL may be configured to provide gate drive signals to the plurality of sub-pixels PX. For example, the gate drive signals may include a scan signal, or may include a scan signal and a light emitting control signal, or may include a scan signal, a reset control signal, and a light emitting control signal.

In some examples, as shown in FIG. 1, the first direction X may be an extension direction (e.g., a row direction) of a gate line GL in the display region AA, and the second direction Y may be an extension direction (e.g., a column direction) of a data line DL in the display region AA. The first direction X and the second direction Y may intersect with each other, for example, they may be perpendicular to each other.

In some examples, one pixel unit of the display region AA may include three sub-pixels, which may be a first sub-pixel emitting light of a first color (e.g., red light), a second sub-pixel emitting light of a second color (e.g., green light), and a third sub-pixel emitting light of a third color (e.g., blue light), respectively. However, the present embodiment is not limited thereto. In some examples, one pixel unit may include four sub-pixels, which may be a sub-pixel emitting red light, a sub-pixel emitting green light, a sub-pixel emitting blue light, and a sub-pixel emitting white light, respectively. For another example, one pixel unit may include four sub-pixels, which may include one sub-pixel emitting red light, one sub-pixel emitting blue light, and two sub-pixels emitting green light.

In some examples, a shape of a sub-pixel may be a rectangle, a rhombus, a pentagon, or a hexagon. When one pixel unit includes three sub-pixels, the three sub-pixels may be arranged side by side horizontally, side by side vertically, or arranged in a manner of a Chinese character " 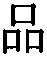 ". When one pixel unit includes four sub-pixels, the four sub-pixels may be arranged side by side horizontally, side by side vertically, or in a manner to form a square. However, the present embodiment is not limited thereto.

In some examples, one sub-pixel may include a pixel circuit and a light emitting element electrically connected with the pixel circuit. The pixel circuit may include a plurality of transistors and at least one capacitor. For example, the pixel circuit may have a 3T1C, 4T1C, ST1C, 5T2C, 6T1C, 7T1C, or 8T1C structure. In the aforementioned circuit structures, T refers to a thin film transistor, C refers to a capacitor, a digit before T represents a quantity of thin film transistors in the circuit, and a digit before C represents a quantity of capacitors in the circuit. In some examples, the plurality of transistors in the pixel circuit may be P-type transistors or may be N-type transistors. Use of a same type of transistors in the pixel circuit may simplify a process flow, reduce process difficulties of the display panel, and improve a yield of products. In some other examples, the plurality of transistors in the pixel circuit may include a P-type transistor and an N-type transistor.

In some examples, low temperature poly silicon thin film transistors, or oxide thin film transistors, or both a low temperature poly silicon thin film transistor and an oxide thin film transistor may be adopted for the plurality of transistors in the pixel circuit. Low Temperature Poly Silicon (LTPS) is adopted for an active layer of a low temperature poly silicon thin film transistor and an oxide semiconductor (Oxide) is adopted for an active layer of an oxide thin film transistor. The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display panel, that is, an LTPS + Oxide (LTPO for short) display panel, so that advantages of both the low temperature poly silicon thin film transistor and the oxide thin film transistor may be utilized, low-frequency drive may be achieved, power consumption may be reduced, and display quality may be improved.

In some examples, the light emitting element may be any one of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, or the like under drive of a pixel circuit corresponding to the light emitting element. A color of light emitted by the light emitting element may be determined as needed. In some examples, the light emitting element may include an anode, a cathode, and an organic emitting layer located between the anode and the cathode. The anode of the light emitting element may be electrically connected with a corresponding pixel circuit. However, the present embodiment is not limited thereto.

FIG. 2 is a schematic partial cross-sectional view of a display region of a display panel according to at least one embodiment of the present disclosure. FIG. 2 is illustrated by taking a structure of one sub-pixel of the display region as an example. In the present example, description is given by taking a case that a plurality of transistors in a pixel circuit are of a same type as an example. For example, a plurality of transistors in a pixel circuit may all be low temperature poly silicon thin film transistors or may all be oxide thin film transistors.

In some examples, as shown in FIG. 2, in a direction perpendicular to the display panel, the display region of the display panel may include a base substrate 10, and a circuit structure layer 12, a light emitting structure layer 13, an encapsulation structure layer 14, and a touch structure layer 50 that are sequentially disposed on the base substrate 10. The display structure layer may include at least a circuit structure layer 12 and a light emitting structure layer 13. The circuit structure layer 12 may include at least pixel circuits of a plurality of sub-pixels, and a pixel circuit of each sub-pixel may include a plurality of transistors and at least one capacitor. The light emitting structure layer 13 may include at least light emitting elements of a plurality of sub-pixels.

In some examples, FIG. 2 is illustrated by taking a case in which a thin film transistor 21 and a capacitor 22 are included in each sub-pixel as an example. In some examples, the circuit structure layer 12 of the display region may include: a semiconductor layer, a first gate metal layer, a second gate metal layer, and a first source-drain metal layer, which are disposed on the base substrate 10. A first gate insulation layer 101 may be disposed between the semiconductor layer and the first gate metal layer, a second gate insulation layer 102 may be disposed between the first gate metal layer and the second gate metal layer, an interlayer dielectric layer 103 may be disposed between the second gate metal layer and the first source-drain metal layer, and a passivation layer 104 and a first planarization layer 105 may be disposed on a side of the first source-drain metal layer away from the base substrate 10. Among them, the first gate insulation layer 101, the second gate insulation layer 102, the interlayer dielectric layer 103, and the passivation layer 104 may be inorganic insulation layers, and the first planarization layer 105 may be organic insulation layers. However, the present embodiment is not limited thereto. In other examples, a side of the semiconductor layer close to the base substrate may also be provided with a buffer layer, which may prevent harmful substances in the base substrate from intruding into interior of the display panel, and may also increase adhesion of a film layer in the display panel on the base substrate. In other examples, the passivation layer may be omitted on a side of the first source-drain metal layer away from the base substrate, and only the first planarization layer may be provided.

In some examples, as shown in FIG. 2, the semiconductor layer of the display region may include at least an active layer 210 of the thin film transistor 21. The active layer 210 of the thin film transistor 21 may include a first region 2101, a second region 2102, and a channel region 2100 located between the first region 2101 and the second region 2102. The first gate metal layer may include at least a gate 213 of the thin film transistor 21 and a first electrode plate 221 of the capacitor 22. An orthographic projection of the gate 213 of the thin film transistor 21 on the base substrate 10 may cover an orthographic projection of the channel region 2100 of the active layer 210 on the base substrate 10. The second gate metal layer may include at least a second electrode plate 222 of the capacitor 22. Orthographic projections of the second electrode plate 222 and the first electrode plate 221 of the capacitor 22 on the base substrate 10 may be at least partially overlapped, for example, the two may coincide. The first source-drain metal layer may include at least a source 211 and a drain 212 of the thin film transistor 21. The interlayer dielectric layer 103 may be provided with a plurality of vias (for example, including a first pixel via and a second pixel via) in the display region, and the interlayer dielectric layer 103, the second gate insulation layer 102, and the first gate insulation layer 101 within the first pixel via may be removed to expose at least a part of a surface of the first region 2101 of the active layer 210; the interlayer dielectric layer 103, the second gate insulation layer 102, and the first gate insulation layer 101 within the second pixel via may be removed to expose at least a part of a surface of the second region 2102 of the active layer 210. The source 211 of the thin film transistor 21 may be electrically connected with the first region 2101 of the active layer 210 through the first pixel via, and the drain 212 may be electrically connected with the second region 2102 of the active layer 210 through the second pixel via. In some examples, a gate line of the display region, for example, may be located in the first gate metal layer, and a data line and a high-potential power supply line of the display region, for example, may be located in the first source-drain metal layer.

In some examples, as shown in FIG. 2, the light emitting structure layer 13 may include a pixel definition layer 134 and a plurality of light emitting elements. For example, each light emitting element may include a first electrode 131, an organic emitting layer 132, and a second electrode 133 which are stacked. The first electrode 131 of the light emitting element may be an anode, and the first electrode 131 may be disposed on the first planarization layer 105 and electrically connected with the second electrode 212 of the thin film transistor through a pixel via disposed in the first planarization layer 105 and the passivation layer 104. The pixel definition layer 134 is disposed on the first electrode 131 and the first planarization layer 105, and the pixel definition layer 134 may be provided with a plurality of pixel openings, one pixel opening may expose at least part of a surface of a corresponding first electrode 131. At least portion of the organic emitting layer 132 may be disposed within one pixel opening and connected with a corresponding first electrode 131. The second electrode 133 may be disposed on the organic emitting layer 132 and be connected with the organic emitting layer 132. The organic emitting layer 132 may emit light of a corresponding color under drive of the first electrode 131 and the second electrode 133.

In some examples, the organic emitting layer 132 of the light emitting element may include an Emitting Layer (EML), and include one or more film layers of a Hole Injection Layer (HIL), a Hole Transport Layer (HTL), a Hole Block Layer (HBL), an Electron Block Layer (EBL), an Electron Injection Layer (EIL), and an Electron Transport Layer (ETL). Under drive of voltages of the first electrode 131 and the second electrode 133, light may be emitted according to a required gray scale, in virtue of light emitting characteristics of an organic material.

In some examples, emitting layers of light emitting elements emitting light of different colors may be different. For example, a red light emitting element includes a red emitting layer, a green light emitting element includes a green emitting layer, and a blue light emitting element includes a blue emitting layer. In order to reduce a process difficulty and improve a yield, a common layer may be adopted for a hole injection layer and a hole transport layer located on one side of an emitting layer, and a common layer may be adopted for an electron injection layer and an electron transport layer located on the other side of the emitting layer. In some examples, any one or more layers of the hole injection layer, the hole transport layer, the electron injection layer, and the electron transport layer may be made through one process (one evaporation process or one inkjet printing process), and isolation may be achieved by means of a formed film layer surface segment difference or by means of a surface treatment. For example, any one or more of hole injection layers, hole transport layers, electron injection layers, and electron transport layers corresponding to adjacent sub-pixels may be isolated. In some examples, the organic emitting layer may be prepared and formed through evaporation using a Fine Metal Mask (FMM) or an open mask, or prepared and formed using an inkjet process.

In some examples, as shown in FIG. 2, the encapsulation structure layer 14 may include a first encapsulation layer 141, a second encapsulation layer 142, and a third encapsulation layer 143 which are stacked. Among them, the first encapsulation layer 141 and the third encapsulation layer 143 may be made of an inorganic material, the second encapsulation layer 142 may be made of an organic material, and the second encapsulation layer 142 may be disposed between the first encapsulation layer 141 and the third encapsulation layer 143 to ensure that external water vapor cannot enter the light emitting element. However, the present embodiment is not limited thereto. For example, the encapsulation structure layer may be of a five-layer stacked structure of inorganic/organic/inorganic/organic/inorganic.

In some examples, the touch structure layer 15 may include a plurality of touch units. At least one touch unit may include at least one touch electrode. An orthographic projection of the at least one touch electrode on the base substrate may include orthographic projections of a plurality of sub-pixels on the base substrate. When the touch unit includes a plurality of touch electrodes, the plurality of touch electrodes may be disposed at intervals, and adjacent touch electrodes may be connected with each other through a connection portion. A touch electrode and the connection portion may be of a same layer structure. In some examples, the touch electrode may be in a shape of a rhombus, such as a regular rhombus, a horizontally long rhombus, or a longitudinally long rhombus. However, the present embodiment is not limited thereto. In some examples, the touch electrode may be in any one or more shapes of a triangle, a square, a trapezoid, a parallelogram, a pentagon, a hexagon, and another polygon.

In some examples, as shown in FIG. 1, the first bezel region B1 may include a first fanout region B11, a bending region B12, a second fanout region B13, a first signal access region B14, and a second signal access region B15 disposed sequentially along a direction away from the display region AA. The first fanout region B11 may be communicated with the second bezel region B2 and be located on a side of the display region AA. The bending region B12 may be communicated with the first fanout region B11 and the second fanout region B13, and be located on a side of the first fanout region B11 away from the display region AA. The second fanout region B13 may be located on a side of the bending region B12 away from the display region AA. The first signal access region B14 may be located on a side of the second fanout region B13 away from the display region AA. The second signal access region B15 may be located on a side of the first signal access region B14 away from the display region AA.

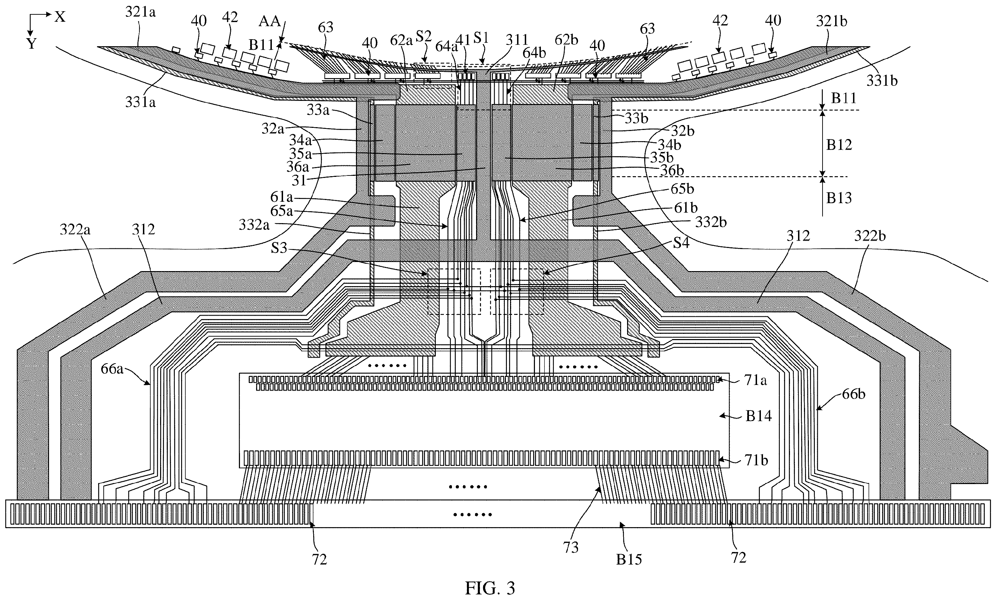

FIG. 3 is a schematic partial plan view of a first bezel region according to at least one embodiment of the present disclosure. In FIG. 3, a panel detection line, a multiplexing data leading-out line, a data bending connection line, a touch bending connection line, a detection bending connection line, a control bending connection line, a multiplexing data line, and a panel detection leading-out line in the first bezel region are illustrated as a whole, a data fanout line, a control leading-out line, a control connection line, and a control signal line are illustrated only by taking several traces as examples, and a quantity of various traces in the first bezel region is not limited in this example.

In some examples, as shown in FIG. 3, the first fanout region B11 may be connected to the display region AA and the second bezel region. The first fanout region B11 may be provided with a first power supply line 311, second power supply lines 321a and 321b, a plurality of display leading-out lines, a plurality of panel detection lines, a plurality of multiplexing circuits 40, a plurality of Electrostatic Discharge (ESD) circuits 41, and a plurality of shift register units 42 of a gate drive circuit.

In some examples, as shown in FIG. 3, the first power supply line 311 may have a first main body portion extending along the second direction Y and a first extension portion extending along an edge of the display region AA, wherein the first main body portion of the first power supply line 311 may be substantially located at a position of a center line of the first fanout region B11 in the first direction X, and the center line of the first fanout region B11 in the first direction X may be parallel to the second direction Y. The first main body portion of the first power supply line 311 may extend towards a side of the bending region B12. The first extension portion of the first power supply line 311 may be electrically connected with a plurality of high-potential power supply lines electrically connected with pixel circuits of a plurality of sub-pixels of the display region AA.

In some examples, as shown in FIG. 3, the second power supply lines 321a and 321b may be located on two opposite sides of the first power supply line 311 in the first direction X. The second power supply line 321a may extend from a left side along an edge of the display panel towards the second bezel region, and the second power supply line 321b may extend from a right side along the edge of the display panel towards the second bezel region. The second power supply lines 321a and 321b may be connected in the second bezel region to provide a low-potential power supply signal to a plurality of sub-pixels of the display region AA. In some examples, the first power supply line 311, and the second power supply lines 321a and 321b may be of a same layer structure, which may be, for example, located in the first source-drain metal layer.

In some examples, the gate drive circuit may include a plurality of cascaded shift register units 42, each of which may be connected with at least one gate line of the display region AA and configured to provide a gate drive signal to at least one gate line of the display region AA. A multiplexing circuit 40 may be configured such that one signal source provides data signals to a plurality of data lines. A part of the multiplexing circuits 40 may be disposed on opposite sides of the first main body portion of the first power supply line 311 in the first direction X and arranged in an array along the first direction X, and the other part of the multiplexing circuits 40 may be disposed at intervals from the shift register units 42 of the gate drive circuit. The shift register units 42 of the gate drive circuit may be arranged along an edge of the display region AA from the first fanout region B11. An electrostatic discharge circuit 41 may be configured to eliminate static electricity on a connected signal line. The plurality of electrostatic discharge circuits 41 may be arranged on opposite sides of the first main body portion of the first power supply line 311 in the first direction X, and may be located on a side of the multiplexing circuit 40 close to the first main body portion of the first power supply line 311.

In some examples, as shown in FIG. 3, the plurality of display leading-out lines of the first fanout region B11 may at least include a plurality of data fanout lines 63, a plurality of control leading-out lines (e.g., including a first set of control leading-out lines 64a and a second set of control leading-out lines 64b), and a plurality of multiplexing data leading-out lines (e.g., including a first set of multiplexing data leading-out lines 62a and a second set of multiplexing data leading-out lines 62b). The plurality of data fanout lines 63 may be electrically connected with the plurality of multiplexing circuits 40 and the plurality of data lines of the display region AA. One end of one data fanout line 63 may be electrically connected with at least one data line of the display region AA, and the other end may be electrically connected with one multiplexing circuit 40. For example, the plurality of data fanout lines 63 may be electrically connected with the plurality of data lines in one-to-one correspondence. One multiplexing circuit 40 may be connected with a plurality of data lines through a plurality of data fanout lines 63 so as to provide data signals to the plurality of data lines. For example, one multiplexing circuit 40 may provide data signals to nine data lines through a plurality of data fanout lines 63. In some examples, adjacent data fanout lines 63 may be located on different metal layers, for example, a plurality of data fanout lines 63 may be disposed at intervals in the first gate metal layer and the second gate metal layer.

In some examples, as shown in FIG. 3, the plurality of multiplexing data leading-out lines may be electrically connected with a plurality of multiplexing circuits 40. One multiplexing data leading-out line may be configured to transmit a data signal to one multiplexing circuit 40, so that the multiplexing circuit 40 supplies the data signal to a plurality of data lines connected with the multiplexing circuit 40. The plurality of multiplexing data leading-out lines may include, for example, a first set of multiplexing data leading-out lines 62a and a second set of multiplexing data leading-out lines 62b. Each set of multiplexing data leading-out lines may include a plurality of multiplexing data leading-out lines, and quantities of two sets of multiplexing data leading-out lines may be the same or different. The first set of multiplexing data leading-out lines 62a and the second set of multiplexing data leading-out lines 62b may be located on two opposite sides of the first main body portion of the first power supply line 311. For example, the first set of multiplexing data leading-out lines 62a may extend to a left side and be connected with a plurality of multiplexing circuits 40 located on the left side of the first main body portion of the first power supply line 311; and the second set of multiplexing data leading-out lines 62b may extend to a right side, and may be connected with a plurality of multiplexing circuits 40 located on the right side of the first main body portion of the first power supply line 311. The plurality of multiplexing data leading-out lines may be located on a side of the second power supply lines 331a and 331b close to the base substrate. The plurality of multiplexing data leading-out lines may be of a same layer structure, for example, may all be located in the second gate metal layer.

In some examples, as shown in FIG. 3, the plurality of control leading-out lines may include, for example, a first set of control leading-out lines 64a and a second set of control leading-out lines 64b. Each set of control leading-out lines may include a plurality of control leading-out lines. Quantities of the two sets of control leading-out lines may be the same or different. The first set of control leading-out lines 64a and the second set of control leading-out lines 64b may be located on two opposite sides of the first main body portion of the first power supply line 311. The first set of control leading-out lines 64a may be located on a side of the first set of multiplexing data leading-out lines 62a close to the first power supply line 311, and the second set of control leading-out lines 64b may be located on a side of the second set of multiplexing data leading-out lines 62b close to the first power supply line 311. A plurality of control leading-out lines may be connected with the electrostatic discharge circuit 41 to avoid accumulation of static electricity.

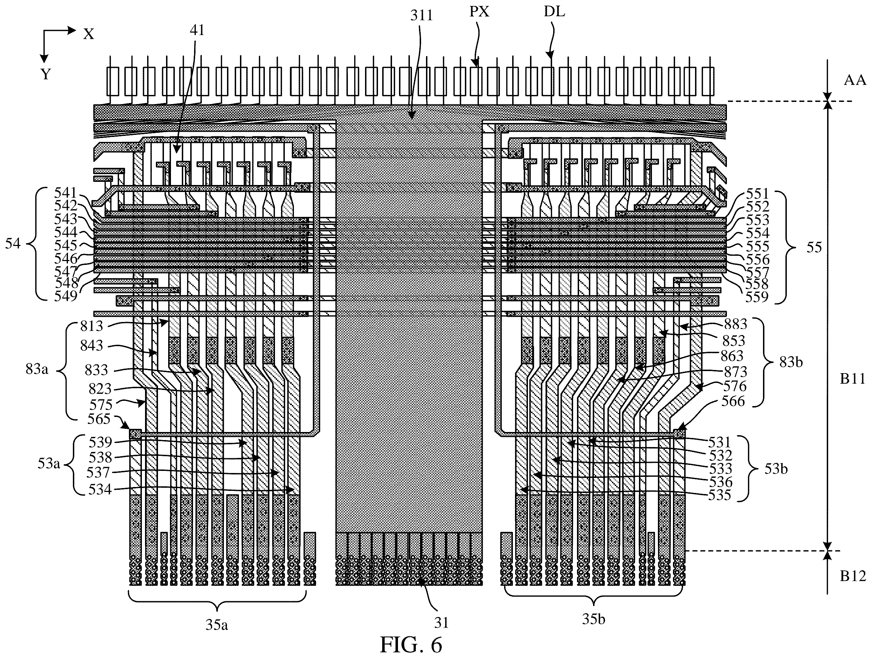

In some examples, the plurality of control leading-out lines may include a plurality of multiplexing control leading-out lines (including, for example, a first set of multiplexing control leading-out lines 53a and a second set of multiplexing control leading-out lines 53b shown in FIG. 6), and a plurality of drive control leading-out lines (including, for example, a first set of drive control leading-out lines 83a and a second set of drive control leading-out lines 83b shown in FIG. 6). The plurality of multiplexing control leading-out lines may be connected with the plurality of multiplexing circuits 40 and may be configured to provide multiplexing control signals to the plurality of multiplexing circuits 40. The plurality of drive control leading-out lines may be connected with the gate drive circuit 42, and may provide, for example, a drive control signal (including, for example, a start signal, a clock signal, a power supply signal, etc.) to the gate drive circuit 42.

In some examples, the plurality of panel detection lines may be configured to perform crack detection of the display region AA. The plurality of panel detection lines may include a first set of panel detection lines 331a and a second set of panel detection lines 331b. An orthographic projection of the first set of panel detection lines 331a on the base substrate may be partially overlapped with an orthographic projection of the second power supply line 321a on the base substrate. An orthographic projection of the second set of panel detection lines 331b on the base substrate may be partially overlapped with an orthographic projection of the second power supply line 321b on the base substrate. For example, the plurality of panel detection lines may be of a same layer structure, for example, all located in the first gate metal layer.

In some examples, as shown in FIG. 3, the bending region B12 may be configured to enable the second fanout region B13, the first signal access region B14, and the second signal access region B15 to be bent to a back of the display region AA. The bending region B12 may be provided with a plurality of bending connection lines to connect traces in the first fanout region B11 and the second fanout region B13 that transmit a same signal. The plurality of bending connection lines in the bending region B12 may be of a same layer structure, for example, may all be located in the first source-drain metal layer.

In some examples, as shown in FIG. 3, the plurality of bending connection lines may include a first power supply bending connection line 31, second power supply bending connection lines 32a and 32b, a first set of detection bending connection lines 33a and a second set of detection bending connection lines 33b, a first set of touch bending connection lines 34a and a second set of touch bending connection lines 34b, a first set of data bending connection lines 36a and a second set of data bending connection lines 36b, and a first set of control bending connection lines 35a and a second set of control bending connection lines 35b. The second power supply bending connection line 32a, the first set of detection bending connection lines 33a, the first set of touch bending connection lines 34a, the first set of data bending connection lines 36a, the first set of control bending connection lines 35a, the first power supply bending connection line 31, the second set of control bending connection lines 35b, the second set of data bending connection lines 36b, the second set of touch bending connection lines 34b, the second set of detection bending connection lines 33b, and the second power supply bending connection line 32b may be sequentially arranged along the first direction X.

In some examples, as shown in FIG. 3, the second fanout region B13 may be provided with at least a first power supply leading-out line 312, second power supply leading-out lines 322a and 322b, a plurality of panel detection leading-out lines (including a first set of panel detection leading-out lines 332a and a second set of panel detection leading-out lines 332b as shown in FIG. 3), a plurality of multiplexing data lines (including a first set of multiplexing data lines 61a and a second set of multiplexing data lines 61b as shown in FIG. 3), a plurality of control connection lines (including a first set of control connection lines 65a and a second set of control connection lines 65b as shown in FIG. 3), and a plurality of control signal lines (including a first set of control signal lines 66a and a second set of control signal lines 66b as shown in FIG. 3).

In some examples, as shown in FIG. 3, the first power supply leading-out line 312 may be connected with the first power supply line 311 of the first fanout region B11 through a first power supply connection line 31 of the bending region B12. For example, the first power supply leading-out line 312, the first power supply connection line 31, and the first power supply line 311 may be of an interconnected integral structure, and for example, they are all located in the first source-drain metal layer. The first power supply leading-out line 312 may include a second main body portion extending along the second direction Y, and a second extension portion and a third extension portion connected with the second main body portion. The second extension portion and the third extension portion may extend along two opposite sides of the first direction X to bypass the first signal access region B14 and extend towards the second signal access region B15. For example, the second extension portion of the first power supply leading-out line 312 may bypass the first signal access region B14 from a left side, and the second extension portion of the first power supply leading-out line 312 may bypass the first signal access region B14 from a right side.

In some examples, as shown in FIG. 3, the second power supply leading-out line 322a may be connected with the second power supply line 321a through the second power supply connection line 32a of the bending region B12. The second power supply leading-out line 322b may be located on a side of the second extension portion of the first power supply leading-out line 312 close to an edge of the display panel. For example, the second power supply leading-out line 322a, the second power supply connection line 32a, and the second power supply line 321a may be of an interconnected integral structure, and for example, they are all located in the first source-drain metal layer. The second power supply leading-out line 322b may be connected with the second power supply line 321b through the second power supply connection line 32b of the bending region B12. The second power supply leading-out line 322b may be located on a side of the third extension portion of the first power supply leading-out line 312 close to an edge of the display panel. For example, the second power supply leading-out line 322b, the second power supply connection line 32b, and the second power supply line 321b may be of an interconnected integral structure, and for example, they are all located in the first source-drain metal layer.

In some examples, as shown in FIG. 3, the plurality of panel detection leading-out lines of the second fanout region B13 may include a first set of panel detection leading-out lines 332a and a second set of panel detection leading-out lines 332b. A plurality of panel detection leading-out lines of the first set of panel detection leading-out lines 332a may be connected with a plurality of panel detection lines of the first set of panel detection lines 331a within the first fanout region B11 through a plurality of detection bending connection lines of the first set of detection bending connection lines 33a of the bending region B12. A plurality of panel detection leading-out lines of the second set of panel detection leading-out lines 332b may be connected with a plurality of panel detection lines of the first set of panel detection lines 331b within the first fanout region B11 through a plurality of detection bending connection lines of the second set of detection bending connection lines 33b of the bending region B12. The first set of panel detection leading-out lines 332a may be located on a side of the second power supply leading-out line 322a away from an edge of the display panel. The second set of panel detection leading-out lines 332b may be located on a side of the second power supply leading-out line 322b away from an edge of the display panel. In some examples, the plurality of panel detection leading-out lines may be of a same layer structure, for example, may all be located in the second gate metal layer.

In some examples, as shown in FIG. 3, the plurality of multiplexing data lines of the second fanout region B13 may extend substantially along the second direction Y towards the first signal access region B14. The plurality of multiplexing data lines may include a first set of multiplexing data lines 61a and a second set of multiplexing data lines 61b. A plurality of multiplexing data lines of the first set of multiplexing data lines 61a may be connected with a plurality of multiplexing data leading-out lines of the first set of multiplexing data leading-out lines 62a within the first fanout region B11 through a plurality of data bending connection lines of the first set of data bending connection lines 36a of the bending region B12. A plurality of multiplexing data lines of the second set of multiplexing data lines 61b may be connected with a plurality of multiplexing data leading-out lines of the second set of multiplexing data leading-out lines 62b within the first fanout region B11 through a plurality of data bending connection lines of the second set of data bending connection lines 36b of the bending region B12. For example, the first set of multiplexing data lines 61a may be configured to provide data signals to sub-pixels within a left half region of the display region AA, and the second set of multiplexing data lines 61b may be configured to provide data signals to sub-pixels within a right half region of the display region AA.

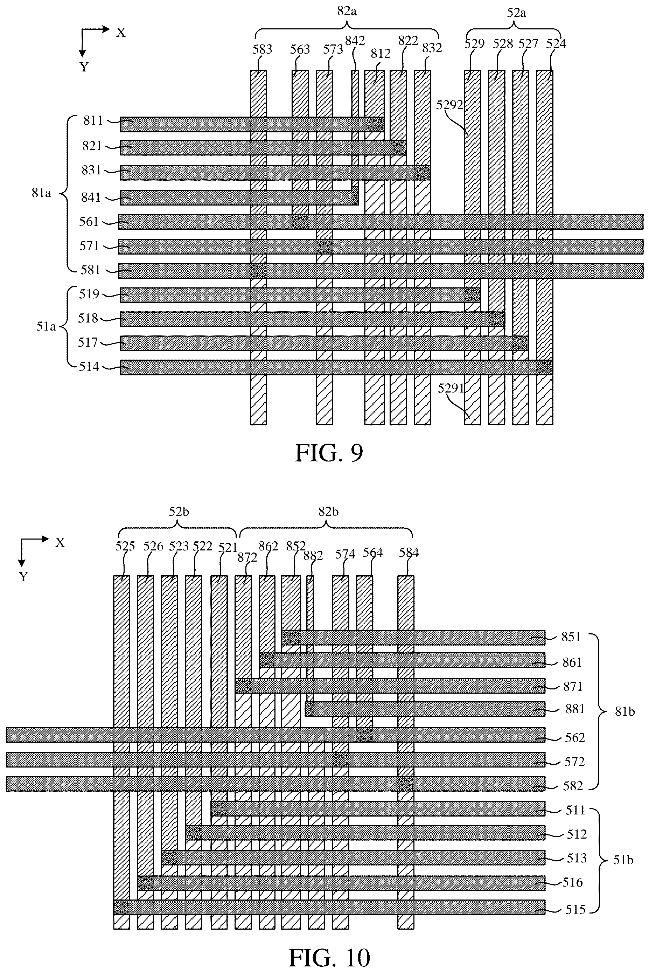

In some examples, as shown in FIG. 3, a plurality of control connection lines of the second fanout region B13 may extend along the second direction Y towards the first signal access region B14. The plurality of control connection lines may include a first set of control connection lines 65a (including, for example, a first set of multiplexing control connection lines 52a and a first set of drive control connection lines 82a shown in FIG. 9) and a second set of control connection lines 65b (including, for example, a second set of multiplexing control connection lines 52b and a second set of drive control connection lines 82b shown in FIG. 10). A plurality of control connection lines of the first set of control connection lines 65a may be connected with a plurality of control leading-out lines of the first set of control leading-out lines 64a within the first fanout region B11 through a plurality of control bending connection lines of the first set of control bending connection lines 35a of the bending region B12. A plurality of control connection lines of the second set of control connection lines 65b may be connected with a plurality of control leading-out lines of the second set of control leading-out lines 64b within the first fanout region B11 through a plurality of control bending connection lines of the second set of control bending connection lines 35b of the bending region B12. The first set of control connection lines 65a may be located on a side of the first set of multiplexing data lines 61a close to the second main body portion of the first power supply leading-out line 312, and the second set of control connection lines 65b may be located on a side of the second set of multiplexing data lines 61b close to the second main body portion of the first power supply leading-out line 312.

In some examples, as shown in FIG. 3, the plurality of control signal lines of the second fanout region B13 may include a first set of control signal lines 66a and a second set of control signal lines 66b. The first set of control signal lines 66a may be connected with the first set of control connection lines 65a, and the second set of control signal lines 66b may be connected with the second set of control connection lines 65b. The first set of control signal lines 66a may bypass the first signal access region B14 from one side (e.g., left side) along the first direction X and extend toward the second signal access region B15. The second set of control signal lines 66b may bypass the first signal access region B14 from the other side (e.g., right side) along the first direction X and extend toward the second signal access region B15.

In some examples, the plurality of control signal lines of the second fanout region B13 may include a plurality of multiplexing control lines (including, for example, a first set of multiplexing control lines 51a shown in FIG. 9 and a second set of multiplexing control lines 51b shown in FIG. 10) and a plurality of drive control lines (including, for example, a first set of drive control lines 81a shown in FIG. 9 and a second set of drive control lines 81b shown in FIG. 10). The plurality of multiplexing control lines may be connected with a plurality of multiplexing control leading-out lines (including, for example, a first set of multiplexing control leading-out lines 53a and a second set of multiplexing control leading-out lines 53b shown in FIG. 6) of the first fanout region B11, and be configured to provide multiplexing control signals to the multiplexing circuits. The plurality of drive control lines may be connected with the plurality of drive control leading-out lines (including, for example, a first set of drive control leading-out lines 83a and a second set of drive control leading-out lines 83b shown in FIG. 6) of the first fanout region B11, and be configured to provide drive control signals (including, for example, a start signal, a clock signal, a voltage signal, etc.) to the gate drive circuit.

In some examples, as shown in FIG. 3, the first signal access region B14 may be configured to provide a drive chip (Integrated Circuit (IC)), for example, the drive chip provided in the first signal access region B14 may be a display drive chip or may be a Touch and Display Driver Integration chip (TDDI). The first signal access region B14 may also be referred to as a drive chip disposing region. The drive chip may be configured to generate data signals required for driving sub-pixels and to provide the data signals to data lines of the display region.

In some examples, as shown in FIG. 3, the first signal access region B14 may be provided with a plurality of first contact pads. The plurality of first contact pads may include a first set of first contact pads 71a and a second set of first contact pads 71b. The second set of first contact pads 71b may be located on a side of the first set of first contact pads 71a away from the display region AA. A plurality of first contact pads within the first set of first contact pads 71a may be arranged in an array in at least one row along the first direction X. A plurality of multiplexing data lines (including, for example, a first set of multiplexing data lines 61a and a second set of multiplexing data lines 61b) within the second fanout region B13 may be electrically connected with a plurality of first contact pads within the first set of first contact pads 71a within the first signal access region B14 to be configured to receive data signals from the drive chip. A plurality of first contact pads within the second set of first contact pads 71b may be arranged in one row along the first direction X.

In some examples, as shown in FIG. 3, the second signal access region B15 may be provided with a plurality of second contact pads 72, and the plurality of second contact pads 72 may be configured to bind a Flexible Printed Circuit (FPC), such that a plurality of signal lines (e.g., a control signal line, a power supply line, etc.) are connected with an external control apparatus through the plurality of second contact pads 72. The second signal access region B15 may also be referred to as a circuit binding region. The second set of first contact pads 71b within the first signal access region B14 may be electrically connected with the plurality of second contact pads 72 within the second signal access region B15 through a plurality of pin connection lines 73.

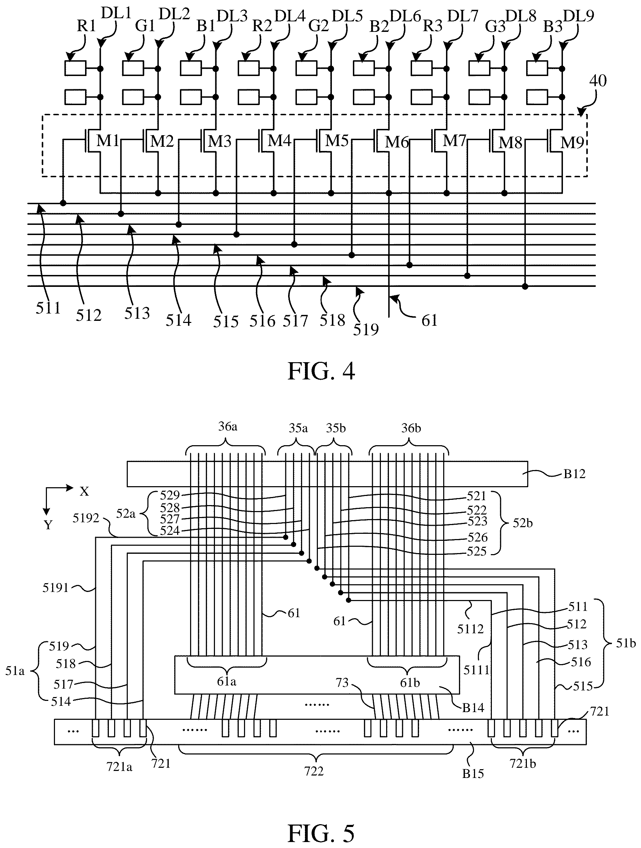

In some examples, the plurality of second contact pads 72 may include a plurality of multiplexing control contact pads (e.g., multiplexing control contact pads 721 shown in FIG. 5). The plurality of multiplexing control lines may extend to be electrically connected with a plurality of multiplexing control contact pads within the second signal access region B15, and the plurality of multiplexing control lines may be configured to receive multiplexing control signals through the multiplexing control contact pads within the second signal access region B15.

FIG. 4 is an equivalent circuit diagram of a multiplexing circuit according to at least one embodiment of the present disclosure. FIG. 4 is illustrated by taking one multiplexing circuit 40 as an example. In some examples, as shown in FIG. 4, one multiplexing circuit 40 may be electrically connected with nine multiplexing control lines, one multiplexing data line 61, and a plurality of data lines (e.g., a first data line DL1 to a ninth data line DL9). The multiplexing circuit 40 may include nine multiplexing transistors (i.e., a first multiplexing transistor M1 to a ninth multiplexing transistor M9). Gates of the nine multiplexing transistors may be connected with different multiplexing control lines, that is, a gate of the first multiplexing transistor M1 is connected with a first multiplexing control line 511, a gate of the second multiplexing transistor M2 is connected with a second multiplexing control line 512, a gate of the third multiplexing transistor M3 is connected with a third multiplexing control line 513, a gate of the fourth multiplexing transistor M4 is connected with a fourth multiplexing control line 514, a gate of the fifth multiplexing transistor M5 is connected with a fifth multiplexing control line 515, a gate of the sixth multiplexing transistor M6 is connected with a sixth multiplexing control line 516, a gate of the seventh multiplexing transistor M7 is connected with a seventh multiplexing control line 517, a gate of the eighth multiplexing transistor M8 is connected with an eighth multiplexing control line 518, and a gate of the ninth multiplexing transistor M9 is connected with a ninth multiplexing control line 519.

In some examples, first electrodes of the nine multiplexing transistors may all be connected with a same multiplexing data line 61. Second electrodes of the nine multiplexing transistors are respectively connected with different data lines of the display region. For example, a second electrode of the first multiplexing transistor M1 is connected with a first data line DL1, a second electrode of the second multiplexing transistor M2 is connected with a second data line DL2, a second electrode of the third multiplexing transistor M3 is connected with a third data line DL3, a second electrode of the fourth multiplexing transistor M4 is connected with a fourth data line DL4, a second electrode of the fifth multiplexing transistor M5 is connected with a fifth data line DL5, a second electrode of the sixth multiplexing transistor M6 is connected with a sixth data line DL6, a second electrode of the seventh multiplexing transistor M7 is connected with a seventh data line DL7, a second electrode of the eighth multiplexing transistor M8 is connected with an eighth data line DL8, and a second electrode of the ninth multiplexing transistor M9 is connected with a ninth data line DL9.

In some examples, the plurality of sub-pixels of the display region may include a first set of sub-pixels, a second set of sub-pixels, and a third set of sub-pixels. The first set of sub-pixels may include a first set of first sub-pixels, a first set of second sub-pixels, and a first set of third sub-pixels, the second set of sub-pixels may include a second set of first sub-pixels, a second set of second sub-pixels, and a second set of third sub-pixels, and the third set of sub-pixels may include a third set of first sub-pixels, a third set of second sub-pixels, and a third set of third sub-pixels.

In some examples, the first data line DL1 may be connected with a first set of first sub-pixels R1 emitting light of the first color, and configured to provide data signals to the first set of first sub-pixels R1. The second data line DL2 may be connected with a first set of second sub-pixels G1 emitting light of the second color, and configured to provide data signals to the first set of second sub-pixels G1. The third data line DL3 may be connected with a first set of third sub-pixels B1 and configured to provide data signals to the first set of third sub-pixels B1. The fourth data line DL4 may be connected with a second set of first sub-pixels R2 and configured to provide data signals to the second set of first sub-pixels R2. The fifth data line DL5 may be connected with a second set of second sub-pixels G2 and configured to provide data signals to the second set of second sub-pixels G2. The sixth data line DL6 may be connected with a second set of third sub-pixels B2 and configured to provide data signals to the second set of third sub-pixels B2. The seventh data line DL7 may be connected with a third set of first sub-pixels R3 and configured to provide data signals to the third set of first sub-pixels R3. The eighth data line DL8 may be connected with a third set of second sub-pixels G3 and configured to provide data signals to the third set of second sub-pixels G3. The ninth data line GL9 may be connected with a third set of third sub-pixels B3 and configured to provide data signals to the third set of third sub-pixels B3. In the present embodiment, a set of sub-pixels may include at least one column of sub-pixels of the display region, and a column of sub-pixels may include, for example, a plurality of sub-pixels arranged along the second direction Y. For example, the light of the first color may be red light, the light of the second color may be green light, and the light of the third color may be blue light.

In some examples, the nine multiplexing control lines may control a plurality of multiplexing circuits 40 to provide data signals to sub-pixels of the display region. As shown in FIG. 4, the first multiplexing control line 511 may be configured to provide a first multiplexing control signal to control a multiplexing circuit 40 to provide data signals to the first set of first sub-pixels R1. The second multiplexing control line 512 may be configured to provide a second multiplexing control signal to control a multiplexing circuit 40 to provide data signals to the first set of second sub-pixels G1. The third multiplexing control line 513 may be configured to provide a third multiplexing control signal to control a multiplexing circuit 40 to provide data signals to the first set of third sub-pixels B1. The fourth multiplexing control line 514 may be configured to provide a fourth multiplexing control signal to control a multiplexing circuit 40 to provide data signals to the second set of first sub-pixels R2. The fifth multiplexing control line 515 may be configured to provide a fifth multiplexing control signal to control a multiplexing circuit 40 to provide data signals to the second set of second sub-pixels G2. The sixth multiplexing control line 516 may be configured to provide a sixth multiplexing control signal to control a multiplexing circuit 40 to provide data signals to the second set of third sub-pixels B2. The seventh multiplexing control line 517 may be configured to provide a seventh multiplexing control signal to control a multiplexing circuit 40 to provide data signals to the third set of first sub-pixels R3. The eighth multiplexing control line 518 may be configured to provide an eighth multiplexing control signal to control a multiplexing circuit 40 to provide data signals to the third set of second sub-pixels G3. The ninth multiplexing control line 519 may be configured to provide a ninth multiplexing control signal to control a multiplexing circuit 40 to provide data signals to the third set of third sub-pixels B3.

In some examples, as shown in FIG. 3, a plurality of multiplexing circuits 40 may be disposed within the first fanout region B11, a plurality of multiplexing control lines (e.g., included within the first set of control signal lines 66a and the second set of control signal lines 66b) may be located in the second fanout region B13, and the plurality of multiplexing control lines may be electrically connected with the plurality of multiplexing circuits 40 through a plurality of control bending connection lines (including, for example, the first set of control bending connection lines 35a and the second set of control bending connection lines 35b) within the bending region B12 and a plurality of multiplexing control leading-out lines (including, for example, the first set of control leading-out lines 64a and the second set of control leading-out lines 64b) within the first fanout region B11. A plurality of multiplexing data lines (including, for example, the first set of multiplexing data lines 61a and the second set of multiplexing data lines 61b) are located in the second fanout region B13, and the plurality of multiplexing data lines may be connected with a plurality of multiplexing data leading-out lines (including, for example, the first set of multiplexing data leading-out lines 62a and the second set of multiplexing data leading-out lines 62b) within the first fanout region B11 through a plurality of data bending connection lines (including, for example, the first set of data bending connection lines 36a and the second set of data bending connection lines 36b) within the bending region B12. A multiplexing circuit 40 may be connected with a plurality of data lines of the display region AA through a plurality of data fanout lines 63. Within the second fanout region B13, a plurality of multiplexing control lines, after being connected with a multiplexing control contact pad (for example, the multiplexing control contact pad 721 shown in FIG. 5) of the second signal access region B15, bypass the first signal access region B14 to extend and gather towards a middle region of the first bezel region of the display panel, and then extend towards a direction close to the display region AA. A plurality of multiplexing data lines (including, for example, the first set of multiplexing data lines 61a and the second set of multiplexing data lines 61b) are concentrated on a side of the first signal access region B14 close to the display region AA, and the plurality of multiplexing data lines extend substantially towards a side of the display region AA along the second direction Y. In the second fanout region B13 shown in FIG. 3, a plurality of multiplexing data lines are overlapped with a plurality of multiplexing control lines, thereby forming overlapping capacitances.

In some examples, when a 1:9 design as shown in FIG. 4 is adopted for the multiplexing circuit 40 (i.e., the multiplexing circuit 40 provides a data signal of one multiplexing data line 61 to at least nine data lines under control of nine multiplexing control lines), the nine multiplexing control lines cannot be evenly divided into two groups to be wound on both sides of the first signal access region B14, and there may be a difference between a quantity of multiplexing control lines overlapped with each multiplexing data line in the first set of multiplexing data lines 61a and a quantity of multiplexing control lines overlapped with each multiplexing data line in the second set of multiplexing data lines 61b.

FIG. 5 is an exemplary diagram of an arrangement of a multiplexing control line and a multiplexing data line according to at least one embodiment of the present disclosure. FIG. 5 is illustrated by taking a case of only several multiplexing data lines as an example. FIG. 5 is a schematic diagram showing a general trend of a multiplexing control line and a multiplexing data line in a second fanout region of a display panel. In the present embodiment, a quantity of multiplexing data lines is not limited. This example is illustrated by taking a case in which a 1:9 design shown in FIG. 4 is adopted for a multiplexing circuit as an example. In this example, by providing an arrangement mode of nine multiplexing control lines, it is possible to improve local display difference of the display region (for example, there is a display difference on left and right sides of the display region) caused by inconsistency of overlapping capacitances of a plurality of multiplexing data lines and a plurality of multiplexing control lines, and thus improving a display effect.

In some examples, as shown in FIGs. 3 and 5, the plurality of second contact pads within the second signal access region B15 may include a plurality of multiplexing control contact pads 721 and a set of middle contact pads 722. For example, the plurality of second contact pads may be arranged in one row along the first direction X. The set of middle contact pads 722 may include a plurality of contact pads, and the set of middle contact pads 722 may be connected with the second set of first contact pads 71b within the first signal access region B14 through a plurality of pin connection lines 73. The plurality of multiplexing control contact pads 721 may include a first set of multiplexing control contact pads 721a and a second set of multiplexing control contact pads 721b. The first set of multiplexing control contact pads 721a and the second set of multiplexing control contact pads 721b may be located on two opposite sides of the set of middle contact pads 722 along the first direction X.

In some examples, as shown in FIG. 5, the nine multiplexing control lines may include a first set of multiplexing control lines 51a and a second set of multiplexing control lines 51b. The first set of control signal lines 66a in FIG. 3 may include a first set of multiplexing control lines 51a, and the second set of control signal lines 66b may include a second set of multiplexing control lines 51b. The first set of multiplexing control lines 51a may include following four multiplexing control lines: a fourth multiplexing control line 514, a seventh multiplexing control line 517, an eighth multiplexing control line 518, and a ninth multiplexing control line 519. The second set of multiplexing control lines 51b may include following five multiplexing control lines: a first multiplexing control line 511, a second multiplexing control line 512, a third multiplexing control line 513, a sixth multiplexing control line 516, and a fifth multiplexing control line 515. The first set of multiplexing control lines 51a may bypass from one side (for example, a left side) of the first signal access region B14 along the first direction X, and the second set of multiplexing control lines 51b may bypass from the other side (for example, a right side) of the second signal access region B14 along the first direction X.

In some examples, as shown in FIG. 5, the first set of multiplexing control lines 51a may be connected with part of control bending connection lines within the first set of control bending connection lines 35a within the bending region B12 through the first set of multiplexing control connection lines 52a; and the second set of multiplexing control lines 51b may be connected with part of control bending connection lines within the second set of control bending connection lines 35b within the bending region B12 through the second set of multiplexing control connection lines 52b. The first set of multiplexing control connection lines 52a may include a ninth multiplexing control connection line 529, an eighth multiplexing control connection line 528, a seventh multiplexing control connection line 527, and a fourth multiplexing control connection line 524; and the second set of multiplexing control connection lines 52b may include a first multiplexing control connection line 521, a second multiplexing control connection line 522, a third multiplexing control connection line 523, a fifth multiplexing control connection line 525, and a sixth multiplexing control connection line 526. The first multiplexing control connection line 521 is connected with the first multiplexing control line 511, the second multiplexing control connection line 522 is connected with the second multiplexing control line 512, the third multiplexing control connection line 523 is connected with the third multiplexing control line 513, the fourth multiplexing control connection line 524 is connected with the fourth multiplexing control line 514, the fifth multiplexing control connection line 525 is connected with the fifth multiplexing control line 515, the sixth multiplexing control connection line 526 is connected with the sixth multiplexing control line 516, the seventh multiplexing control connection line 527 is connected with the seventh multiplexing control line 517, the eighth multiplexing control connection line 528 is connected with the eighth multiplexing control line 518, and the ninth multiplexing control connection line 529 is connected with the ninth multiplexing control line 519.

In some examples, as shown in FIG. 5, the first set of multiplexing control lines 51a may be connected with the first set of multiplexing control contact pads 721a. For example, each multiplexing control line in the first set of multiplexing control lines 51a may be connected with at least one multiplexing control contact pad 721 within the first set of multiplexing control contact pads 721a. Each multiplexing control line of the first set of multiplexing control lines 51a may include at least a first multiplexing extension segment and a second multiplexing extension segment connected with each other. Taking the ninth multiplexing control line 519 as an example, the ninth multiplexing control line 519 may include a first multiplexing extension segment 5191 and a second multiplexing extension segment 5192 connected with each other, wherein the first multiplexing extension segment 5191 extends at least along the second direction Y, and the second multiplexing extension segment 5192 extends at least along the first direction X. One end of the first multiplexing extension segment 5191 is connected with part of multiplexing control contact pads 721 within the first set of multiplexing control contact pads 721a, the other end of the first multiplexing extension segment 5191 is connected with one end of the second multiplexing extension segment 5192, and the other end of the second multiplexing extension segment 5192 is connected with a ninth multiplexing control connection line 529 within the first set of multiplexing control connection lines 52a within the first set of control connection lines (for example, the first set of control connection lines 65a shown in FIG. 3). A first multiplexing extension segment of each multiplexing control line within the first set of multiplexing control lines 51a may be located on a side of the first set of multiplexing data lines 61a away from the second set of multiplexing data lines 61b, and a second multiplexing extension segment of each multiplexing control line may span the first set of multiplexing data lines 61a. An orthographic projection of each multiplexing data line 61 within the first set of multiplexing data lines 61a on the base substrate may be overlapped with an orthographic projection of a second extension segment of each multiplexing control line of the first set of multiplexing control lines 51a on the base substrate. Each multiplexing data line 61 within the first set of multiplexing data lines 61a may intersect with a second multiplexing extension segment of each multiplexing control line of the first set of multiplexing control lines 51a. An intersection angle between each multiplexing data line 61 within the first set of multiplexing data lines 61a, and a second multiplexing extension segment of each multiplexing control line within the first set of multiplexing control lines 51a may be substantially the same, and for example, may be 90 degrees. In other examples, intersection angles between a second multiplexing extension segment of at least one multiplexing control line of the first set of multiplexing control lines 51a, and a plurality of multiplexing data lines 61 within the first set of multiplexing data lines 61a may be different. For example, an intersection angle may be less than or equal to 90 degrees.

In some examples, as shown in FIG. 5, the fourth multiplexing control line 514, the seventh multiplexing control line 517, the eighth multiplexing control line 518, and the ninth multiplexing control line 519 within the first set of multiplexing control lines 51a may be sequentially arranged in a direction away from the first signal access region B14. However, an arrangement order of the four multiplexing control lines within the first set of multiplexing control lines 51a is not limited in the present embodiment. For example, the fourth multiplexing control line 514, the seventh multiplexing control line 517, the eighth multiplexing control line 518, and the ninth multiplexing control line 519 may be sequentially arranged in a direction close to the first signal access region B14. For another example, the ninth multiplexing control line 519, the seventh multiplexing control line 517, the eighth multiplexing control line 518, and the fourth multiplexing control line 514 may be sequentially arranged in a direction close to or away from the first signal access region B14.

In some examples, as shown in FIG. 5, the second set of multiplexing control lines 51b may be connected with the second set of multiplexing control contact pads 721b. For example, each multiplexing control line in the second set of multiplexing control lines 51b may be connected with at least one multiplexing control contact pad 721 within the second set of multiplexing control contact pads 721b. Each multiplexing control line of the second set of multiplexing control lines 51b may include at least a third multiplexing extension segment and a fourth multiplexing extension segment connected with each other. Taking the first multiplexing control line 511 as an example, the first multiplexing control line 511 may include a third multiplexing extension segment 5111 and a fourth multiplexing extension segment 5112 connected with each other, wherein the third multiplexing extension segment 5111 may extend at least along the second direction Y, and the fourth multiplexing extension segment 5112 may extend at least along the first direction X. One end of the third multiplexing extension segment 5111 is connected with at least one multiplexing control contact pad 721 within the second set of multiplexing control contact pads 721b, the other end of the third multiplexing extension segment 5111 is connected with one end of the fourth multiplexing extension segment 5112, and the other end of the fourth multiplexing extension segment 5112 is connected with a first multiplexing control connection line 521 within the second set of multiplexing control connection lines 52b within the second set of control connection lines (for example, the second set of control connection lines 65b shown in FIG. 3). A third multiplexing extension segment of each multiplexing control line within the second set of multiplexing control lines 51a may be located on a side of the second set of multiplexing data lines 61b away from the first set of multiplexing data lines 61a, and a fourth multiplexing extension segment of each multiplexing control line may span the second set of multiplexing data lines 61b. An orthographic projection of each multiplexing data line 61 within the second set of multiplexing data lines 61b on the base substrate may be overlapped with an orthographic projection of a fourth multiplexing extension segment of each multiplexing control line of the second set of multiplexing control lines 51b on the base substrate. Each multiplexing data line 61 within the second set of multiplexing data lines 61b may intersect with a fourth multiplexing extension segment of each multiplexing control line of the second set of multiplexing control lines 51b. An intersection angle between each multiplexing data line 61 within the second set of multiplexing data lines 61b, and a fourth multiplexing extension segment of each multiplexing control line of the second set of multiplexing control lines 51b may be substantially the same, and for example, may be 90 degrees. In other examples, intersection angles between a fourth multiplexing extension segment of at least one multiplexing control line of the second set of multiplexing control lines 51b, and a plurality of multiplexing data lines 61 within the second set of multiplexing data lines 61b may be different. For example, an intersection angle may be less than or equal to 90 degrees.

In some examples, as shown in FIG. 5, the first multiplexing control line 511, the second multiplexing control line 512, the third multiplexing control line 513, the sixth multiplexing control line 516, and the fifth multiplexing control line 515 within the second set of multiplexing control lines 51b may be sequentially arranged in a direction away from the first signal access region B14. However, an arrangement order of the five multiplexing control lines within the second set of multiplexing control lines 51b is not limited in the present embodiment. For example, the first multiplexing control line 511, the second multiplexing control line 512, the third multiplexing control line 513, the sixth multiplexing control line 516, and the fifth multiplexing control line 515 may be sequentially arranged in a direction close to the first signal access region B14. For another example, the first multiplexing control line 511, the third multiplexing control line 513, the second multiplexing control line 512, the sixth multiplexing control line 516, and the fifth multiplexing control line 515 may be sequentially arranged in a direction close to or away from the first signal access region B14.

In some examples, as shown in FIG. 5, the first set of multiplexing control lines 51a and the second set of multiplexing control lines 51b converge in a middle region between the first set of multiplexing data lines 61a and the second set of multiplexing data lines 61a after bypassing the first signal access region B14. Orthographic projections of the four multiplexing control lines of the first set of multiplexing control lines 51a on the base substrate are all overlapped with an orthographic projection of each multiplexing data line 61 of the first set of multiplexing data lines 61a on the base substrate, and are not overlapped with orthographic projections of the second set of multiplexing data lines 61b on the base substrate; and orthographic projections of the five multiplexing control lines within the second set of multiplexing control lines 51b on the base substrate are all overlapped with an orthographic projection of each multiplexing data lines 61 within the second set of multiplexing data lines 61b on the base substrate, and are not overlapped with orthographic projections of the first set of multiplexing data lines 61a on the base substrate. In other words, an orthographic projection of each multiplexing data line 61 of the first set of multiplexing data lines 61a on the base substrate is overlapped with the orthographic projections of the four multiplexing control lines on the base substrate, and an orthographic projection of each multiplexing data line 61 of the second set of multiplexing data lines 61b on the base substrate is overlapped with the orthographic projections of the five multiplexing control lines on the base substrate.

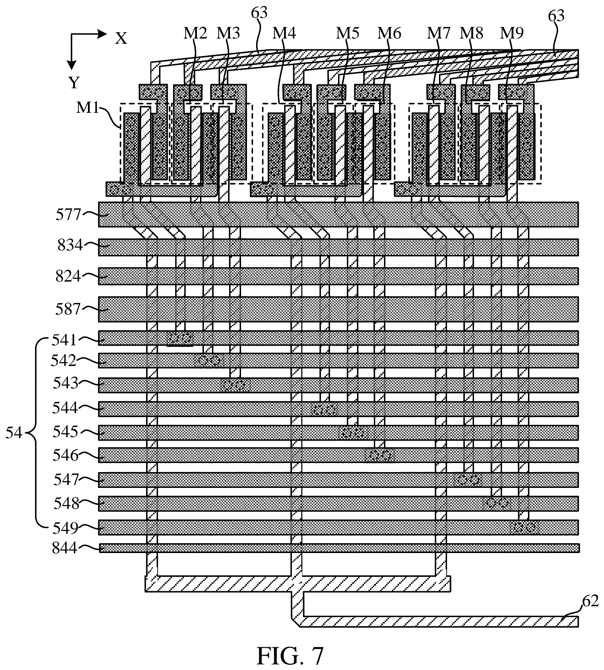

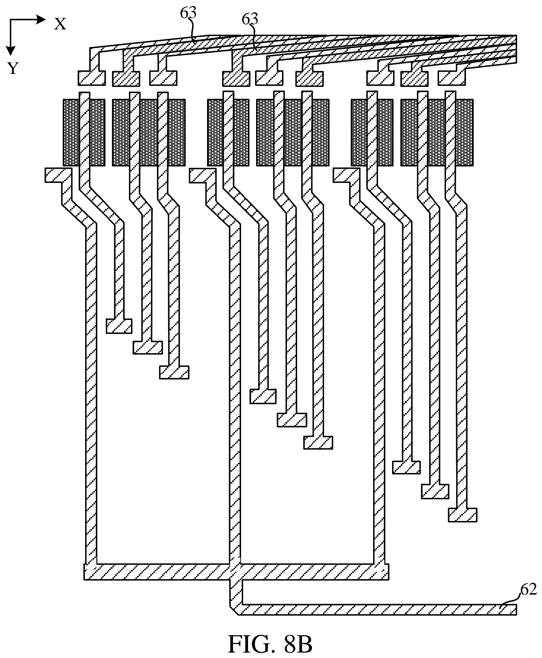

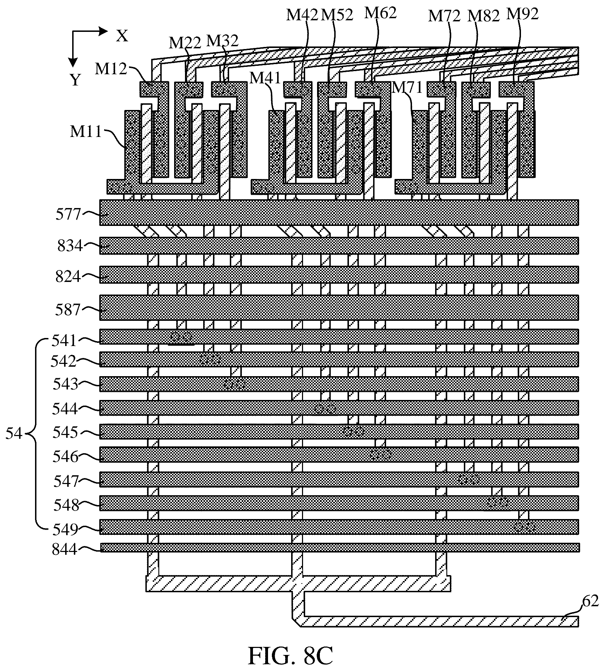

Hereinafter, a part of the first bezel region shown in FIG. 3 will be illustrated by way of example by taking an arrangement mode of traces shown in FIG. 5 as an example. FIG. 6 is a partially enlarged schematic view of a region S1 in FIG. 3. FIG. 7 is a partially enlarged schematic view of a region S2 in FIG. 3. FIG. 8B is a schematic diagram of the display panel after a first gate metal layer is formed in FIG. 7. FIG. 8B is a schematic diagram of the display panel after a second gate metal layer is formed in FIG. 7. FIG. 8C is a schematic diagram of the display panel after a first source-drain metal layer is formed in FIG. 7. FIG. 9 is a partially enlarged schematic view of a region S3 in FIG. 3. FIG. 10 is a partially enlarged schematic view of a region S4 in FIG. 3. FIGs. 7 to 8C are illustrated by taking one multiplexing circuit as an example.

In some examples, as shown in FIGs. 3 and 9, the first set of control signal lines 66a may include at least a first set of multiplexing control lines 51a (i.e., including a ninth multiplexing control line 519, an eighth multiplexing control line 518, a seventh multiplexing control line 517, and a fourth multiplexing control line 514), a first set of drive control lines 81a (e.g., including: a scan start signal line 811, a first scan clock signal line 821, a second scan clock signal line 831, a first scan output line 841, a first initial signal line 561, a first low-voltage line 571, and a first high-voltage line 581). The first set of drive control lines 81a may be located on a side of the first set of multiplexing control lines 51a close to the display region. For example, the scan start signal line 811, the first scan clock signal line 821, the second scan clock signal line 831, the first scan output line 841, the first initial signal line 561, the first low-voltage line 571, the first high-voltage line 581, the ninth multiplexing control line 519, the eighth multiplexing control line 518, the seventh multiplexing control line 517, and the fourth multiplexing control line 514 may be sequentially disposed in the second direction Y along a direction away from the display region.

In some examples, as shown in FIGs. 3 and 9, the first set of control connection lines 65a of the second fanout region B13 may include at least a first set of multiplexing control connection lines 52a (including, for example, a ninth multiplexing control connection line 529, an eighth multiplexing control connection line 528, a seventh multiplexing control connection line 527, and a fourth multiplexing control connection line 524) , a first set of drive control connection lines 82a (including, for example, a scan start connection line 812, a first scan clock connection line 822, a second scan clock connection line 832, a first scan output connection line 842, a first initial connection line 563, a first low-voltage connection line 573, and a first high-voltage connection line 583).

In some examples, as shown in FIG. 9, the ninth multiplexing control connection line 529 is connected with the ninth multiplexing control line 519, the eighth multiplexing control connection line 528 is connected with the eighth multiplexing control line 518, the seventh multiplexing control connection line 527 is connected with the seventh multiplexing control line 517, and the fourth multiplexing control connection line 524 is connected with the fourth multiplexing control line 514. The scan start connection line 812 is connected with the scan start signal line 811, the first scan clock connection line 822 is connected with the first scan clock signal line 821, the second scan clock connection line 832 is connected with the second scan clock signal line 831, the first scan output connection line 842 is connected with the first scan output line 841, the first initial connection line 563 is connected with the initial signal line 561, the first low-voltage connection line 573 is connected with the first voltage line 571, and the first high-voltage connection line 583 is connected with the first high-voltage line 581.

In some examples, as shown in FIGs. 3 and 9, the first set of multiplexing control connection lines 52a and the first set of drive control connection lines 82a of the first set of control connection lines 65a may extend to the bending region B12 along the second direction Y and be connected with the first set of control bending connection lines 35a of the bending region B12. The first set of drive control connection lines 82a within the first set of control connection lines 65a may be located on a side of the first set of multiplexing control connection lines 52a close to the first set of multiplexing data lines 61a in the first direction X. For example, the first high-voltage connection line 583, the first initial connection line 563, the first low-voltage connection line 573, the first scan output connection line 842, the scan start connection line 812, the first scan clock connection line 822, the second scan clock connection line 832, the ninth multiplexing control connection line 529, the eighth multiplexing control connection line 528, the seventh multiplexing control connection line 527, and the fourth multiplexing control connection line 524 may be sequentially disposed along a direction away from the first set of multiplexing data lines 61a in the first direction X. In this example, the first high-voltage connection line 583, the first initial connection line 563, and the first low-voltage connection line 573 that transmit constant-voltage signals are disposed on a side of four multiplexing control connection lines close to the first set of multiplexing data lines 61a, which may avoid interference of the first set of multiplexing control connection lines 52a on the first set of multiplexing data lines 61a.

In some examples, as shown in FIGs. 3 and 9, the first set of control signal lines 66a may be of a same layer structure, and for example, all are located in the first source-drain metal layer. Traces within the first set of control connection lines 65a may all be, for example, double-layer traces, and may be, for example, located in the first gate metal layer and the second gate metal layer. For example, the ninth multiplexing control connection line 529 may include a first trace 5291 located in the first gate metal layer and a second trace 5292 located in the second gate metal layer, and the ninth multiplexing control line 519 may be located in the first source-drain metal layer. The ninth multiplexing control line 519 may be connected with the first trace 5291 and the second trace 5292 of the ninth multiplexing control connection line 529 through a via opened in an insulation layer. The first trace 5291 of the ninth multiplexing control connection line 529 may extend to the first signal access region B14 along the second direction Y, and may be connected with, for example, a first invalid contact pad (not shown) within the first signal access region B14. In other examples, the ninth multiplexing control line 519 may also be connected with a second invalid contact pad (not shown) within the first signal access region B14 through a connection line at a position bypassing the first signal access region B14, and the second invalid contact pad may be located on a side of a first contact pad connected with the first set of multiplexing data lines 61a away from the first invalid contact pad in the first direction X; and the first invalid contact pad and the second invalid contact pad may be electrically connected through a contact pad connection line, and by providing a parallel line of the ninth multiplexing control line in the first signal access region B14, it is beneficial to reduce a resistance of the ninth multiplexing control line. Film layer structures of remaining control signal lines and control connection lines are substantially the same, and thus will not be repeated here.

In some examples, as shown in FIGs. 3 and 10, the second set of control signal lines 66b may include at least a second set of multiplexing control lines 51b (i.e., including a first multiplexing control line 511, a second multiplexing control line 512, a third multiplexing control line 513, a sixth multiplexing control line 516, and a fifth multiplexing control line 515), a second set of drive control lines 81b (e.g., including: a light emitting start signal line 851, a first light emitting clock signal line 861, a second light emitting clock signal line 871, a second light emitting output line 881, a second initial signal line 562, a second low-voltage line 572, and a second high-voltage line 582). The second set of drive control lines 81b may be located on a side of the second set of multiplexing control lines 51b close to the display region. For example, the light emitting start signal line 851, the first light emitting clock signal line 861, the second light emitting clock signal line 871, the second light emitting output line 881, the second initial signal line 562, the second low-voltage line 572, the second high-voltage line 582, the first multiplexing control line 511, the second multiplexing control line 512, the third multiplexing control line 513, the sixth multiplexing control line 516, and the fifth multiplexing control line 515 may be sequentially disposed along a direction away from the display region.

In some examples, as shown in FIGs. 3 and 10, the second set of control connection lines 65b of the second fanout region B13 may include at least a second set of multiplexing control connection lines 52b (e.g., including: a first multiplexing control connection line 521, a second multiplexing control connection line 522, a third multiplexing control connection line 523, a sixth multiplexing control connection line 526, and a fifth multiplexing control connection line 525), a second set of drive control connection lines 82b (including, for example,: a light emitting start connection line 852, a first light emitting clock connection line 862, a second light emitting clock connection line 872, a first light emitting output connection line 882, a second initial connection line 564, a second low-voltage connection line 574, and a second high-voltage connection line 584).

In some examples, as shown in FIG. 10, the first multiplexing control connection line 521 is connected with the first multiplexing control line 511, the second multiplexing control connection line 522 is connected with the second multiplexing control line 512, the third multiplexing control connection line 523 is connected with the third multiplexing control line 513, the sixth multiplexing control connection line 526 is connected with the sixth multiplexing control line 516, and the fifth multiplexing control connection line 525 is connected with the fifth multiplexing control line 515. The light emitting start connection line 852 is connected with the light emitting start signal line 851, the first light emitting clock connection line 862 is connected with the first light emitting clock signal line 861, the second light emitting clock connection line 872 is connected with the second light emitting clock signal line 871, the first light emitting output connection line 882 is connected with the first light emitting output line 881, the second initial connection line 564 is connected with the second initial signal line 562, the second low-voltage connection line 574 is connected with the second voltage line 572, and the second high-voltage connection line 584 is connected with the second high-voltage line 582.

In some examples, the first initial signal line 561 and the second initial signal line 562 may be of an interconnected integral structure, and the first initial signal line 561 and the second initial signal line 562 may be configured to transmit an initial signal. The first low-voltage line 571 and the second low-voltage line 572 may be of an interconnected integral structure. The first low-voltage line 571 and the second low-voltage line 572 may be configured to transmit a first voltage signal. The first high-voltage line 581 and the second high-voltage line 572 may be of an interconnected integral structure. The first high-voltage line 581 and the second high-voltage line 582 may be configured to transmit a second voltage signal. The second voltage signal may be greater than the first voltage signal.

In some examples, as shown in FIGs. 3 and 10, the second set of multiplexing control connection lines 52b and the second set of drive control connection lines 82b of the second set of control connection lines 65b may extend to the bending region B12 along the second direction Y and be connected with the second set of control bending connection lines 35b of the bending region B12. The second set of drive control connection lines 82b of the second set of control connection lines 65b may be located on a side of the second set of multiplexing control connection lines 52b close to the second set of multiplexing data lines 61b in the first direction X. For example, the second high-voltage connection line 584, the second initial connection line 564, the second low-voltage connection line 574, the first light emitting output connection line 882, the light emitting start connection line 852, the first light emitting clock connection line 862, the second light emitting clock connection line 872, the first multiplexing control connection line 521, the second multiplexing control connection line 522, the third multiplexing control connection line 523, the sixth multiplexing control connection line 526, and the fifth multiplexing control connection line 525 may be sequentially disposed along a direction away from the second set of multiplexing data lines 61b in the first direction X. In this example, the second high-voltage connection line 584, the second initial connection line 564, and the second low-voltage connection line 574 that transmit constant-voltage signals are disposed on a side of five multiplexing control connection lines close to the second set of multiplexing data lines 61b, which may avoid interference of the second set of multiplexing control connection lines 52b on the second set of multiplexing data lines 61b.

In some examples, as shown in FIGs. 3 and 10, the second set of control signal lines 66b may be of a same layer structure, and for example, all are located in the first source-drain metal layer. Traces within the second set of control connection lines 65b may all be, for example, double-layer traces, and may be, for example, located in the first gate metal layer and the second gate metal layer. Film layer structures of the second set of control signal lines 66b and the second set of control connection lines 65b may be referred to the film layer structures of the first set of control signal lines 66a and the first set of control connection lines 65a, and thus will not be repeated here.

In some examples, as shown in FIG. 6, a first main body portion of the first power supply line 311 of the first fanout region B11 may be located, for example, at a position of the centerline of the first fanout region B11 along the first direction X. The first main body portion of the first power supply line 311 may be electrically connected with the first power supply connection line 31 of the bending region B12, and they may be, for example, of an interconnected integral structure. The first power supply connection line 31 may have a plurality of hollow portions arranged along the second direction Y, and shapes and sizes of the plurality of hollow portions may be substantially the same. In this example, by disposing hollow portions on a bending connection trace of the bending region B 12, stress accumulated on the trace during a bending process may be relieved, which is beneficial to release the stress when the trace is bent, thereby improving a bending effect. Edges of both sides of the first power supply connection line 31 in the first direction X may be of a wavy shape. For example, an edge of the bending connection trace may form a wavy shape by connecting a plurality of arc segments. By setting the edge of the bending connection trace to be wavy, bending stress received by the bending connection trace in the bending process may be dispersed, stress concentration may be avoided, and the bending effect may be improved.

In some examples, as shown in FIGs. 3 and 6, the first set of control leading-out lines 64a on a left side of the first main body portion of the first power supply line 311 of the first fanout region B11 may include a first set of multiplexing control first leading-out lines 53a (for example, including: a ninth multiplexing control first leading-out line 539, an eighth multiplexing control first leading-out line 538, a seventh multiplexing control first leading-out line 537, and a fourth multiplexing control first leading-out line 534), a set of multiplexing control second leading-out lines 54 (including, for example: a ninth multiplexing control second leading-out line 549, an eighth multiplexing control second leading-out line 548, a seventh multiplexing control second leading-out line 547, a sixth multiplexing control second leading-out line 546, a fifth multiplexing control second leading-out line 545, a fourth multiplexing control second leading-out line 544, a third multiplexing control second leading-out line 543, a second multiplexing control second leading-out line 542, and a first multiplexing control second leading-out line 541), a first set of drive control leading-out lines 83a (including, for example: a scan start leading-out line 813, a first scan clock leading-out line 823, a second scan clock leading-out line 833, a first scan output leading-out line 843, a first initial leading-out line 565, a first low-voltage leading-out line 575, and a first high-voltage leading-out line (not shown).

In some examples, as shown in FIG. 6, the ninth multiplexing control first leading-out line 539, the eighth multiplexing control first leading-out line 538, the seventh multiplexing control first leading-out line 537, and the fourth multiplexing control first leading-out line 534 may extend along the second direction Y. The ninth multiplexing control first leading-out line 539, the eighth multiplexing control first leading-out line 538, the seventh multiplexing control first leading-out line 537, and the fourth multiplexing control first leading-out line 534 may be located on a side of the first set of drive control leading-out lines 83a close to the first main body portion of the first power supply line 311 in the first direction X. The ninth multiplexing control first leading-out line 539, the eighth multiplexing control first leading-out line 538, the seventh multiplexing control first leading-out line 537, and the fourth multiplexing control first leading-out line 534 may be sequentially disposed along a direction close to the first main body portion of the first power supply line 311 in the first direction X. The first scan clock leading-out line 823, the second scan clock leading-out line 833, the scan start leading-out line 813, the scan output leading-out line 843, the first low-voltage leading-out line 575, the first initial leading-out line 565, and the first high-voltage leading-out line may be sequentially disposed along the first direction X in a direction in which the ninth multiplexing control first leading-out line 539 is far away from the first main body portion of the first power supply line 311.

In some examples, as shown in FIGs. 3 and 6, the second set of control leading-out lines 64b on a right side of the first main body portion of the first power supply line 311 of the first fanout region B11 may include a second set of multiplexing control first leading-out lines 53b (including, for example, a first multiplexing control first leading-out line 531, a second multiplexing control first leading-out line 532, a third multiplexing control first leading-out line 533, a sixth multiplexing control first leading-out line 536, and a fifth multiplexing control first leading-out line 535), a set of multiplexing control third leading-out lines 55 (including, for example, a ninth multiplexing control third leading-out line 559, an eighth multiplexing control third leading-out line 558, a seventh multiplexing control third leading-out line 557, a sixth multiplexing control third leading-out line 556, a fifth multiplexing control third leading-out line 555, a fourth multiplexing control third leading-out line 554, a third multiplexing control third leading-out line 553, a second multiplexing control third leading-out line 552, and a first multiplexing control third leading-out line 551), a second set of drive control leading-out lines 83b (including, for example, a light emitting start leading-out line 853, a first light emitting clock leading-out line 863, a second light emitting clock leading-out line 873, a first light emitting output leading-out line 883, a second initial leading-out line 566, a second low-voltage leading-out line 576, and a second high-voltage leading-out line (not shown).

In some examples, as shown in FIG. 6, the first multiplexing control first leading-out line 531, the second multiplexing control first leading-out line 532, the third multiplexing control first leading-out line 533, the sixth multiplexing control first leading-out line 536, and the fifth multiplexing control first leading-out line 535 may extend substantially along the second direction Y. The first multiplexing control first leading-out line 531, the second multiplexing control first leading-out line 532, the third multiplexing control first leading-out line 533, the sixth multiplexing control first leading-out line 536, and the fifth multiplexing control first leading-out line 535 may be located on a side of the second set of drive control leading-out lines 83b close to the first main body portion of the first power supply line 311 in the first direction X. The first multiplexing control first leading-out line 531, the second multiplexing control first leading-out line 532, the third multiplexing control first leading-out line 533, the sixth multiplexing control first leading-out line 536, and the fifth multiplexing control first leading-out line 535 may be sequentially disposed in the first direction X along a direction close to the first main body portion of the first power supply line 311. The second light emitting clock leading-out line 873, the first light emitting clock leading-out line 863, the light emitting start leading-out line 853, the light emitting output leading-out line 883, the second low-voltage leading-out line 576, the second initial leading-out line 566, and the second high-voltage leading-out line may be sequentially disposed along the first direction X in a direction in which the first multiplexing control leading-out line 531 is far away from the first main body portion of the first power supply line 311.

In some examples, as shown in FIG. 6, a set of multiplexing control second leading-out lines 54 and a set of multiplexing control third leading-out lines 55 may extend at least along the first direction X. The set of multiplexing control second leading-out lines 54 and the set of multiplexing control third leading-out lines 55 may be of a same layer structure, and may be located, for example, in the first source-drain metal layer. The set of multiplexing control second leading-out lines 54 and the set of multiplexing control third leading-out lines 55 may be electrically connected through a connection line located in the first gate metal layer.

In some examples, as shown in FIG. 6, the ninth multiplexing control second leading-out line 549, the eighth multiplexing control second leading-out line 548, the seventh multiplexing control second leading-out line 547, the sixth multiplexing control second leading-out line 546, the fifth multiplexing control second leading-out line 545, the fourth multiplexing control second leading-out line 544, the third multiplexing control second leading-out line 543, the second multiplexing control second leading-out line 542, and the first multiplexing control second leading-out line 541 may be sequentially disposed in the second direction Y along a direction close to the display region AA. The ninth multiplexing control third leading-out line 559, the eighth multiplexing control third leading-out line 558, the seventh multiplexing control third leading-out line 557, the sixth multiplexing control third leading-out line 556, the fifth multiplexing control third leading-out line 555, the fourth multiplexing control third leading-out line 554, the third multiplexing control third leading-out line 553, the second multiplexing control third leading-out line 552, and the first multiplexing control third leading-out line 551 may be sequentially disposed in the second direction Y along a direction close to the display region AA.

In some examples, the ninth multiplexing control second leading-out line 549 is connected with the ninth multiplexing control first leading-out line 539 through a via disposed in an insulation layer, so that the ninth multiplexing control second leading-out line 549 provides ninth multiplexing control signals to a plurality of multiplexing circuits 40 within a region on a left side of the first power supply line 311; and the ninth multiplexing control second leading-out line 549 is connected with the ninth multiplexing control third leading-out line 559, so that the ninth multiplexing control third leading-out line 559 provides ninth multiplexing control signals to a plurality of multiplexing circuits 40 within a region on a right side of the first power supply line 311.

In some examples, the eighth multiplexing control second leading-out line 548 is connected with the eighth multiplexing control first leading-out line 538 through a via disposed in an insulation layer, so that the eighth multiplexing control second leading-out line 548 provides eighth multiplexing control signals to a plurality of multiplexing circuits 40 within a region on a left side of the first power supply line 311; and the eighth multiplexing control second leading-out line 548 is connected with the eighth multiplexing control third leading-out line 558, so that the eighth multiplexing control third leading-out line 558 provides eighth multiplexing control signals to a plurality of multiplexing circuits 40 within a region on a right side of the first power supply line 311.

In some examples, the seventh multiplexing control second leading-out line 547 is connected with the seventh multiplexing control first leading-out line 537 through a via disposed in an insulation layer, so that the seventh multiplexing control second leading-out line 547 provides seventh multiplexing control signals to a plurality of multiplexing circuits 40 within a region on a left side of the first power supply line 311; and the seventh multiplexing control second leading-out line 547 is connected with the seventh multiplexing control third leading-out line 557, so that the seventh multiplexing control third leading-out line 557 provides seventh multiplexing control signals to a plurality of multiplexing circuits 40 within a region on a right side of the first power supply line 311.

In some examples, the fourth multiplexing control second leading-out line 544 is connected with the fourth multiplexing control first leading-out line 534 through a via disposed in an insulation layer, so that the fourth multiplexing control second leading-out line 544 provides fourth multiplexing control signals to a plurality of multiplexing circuits 40 within a region on a left side of the first power supply line 311; and the fourth multiplexing control second leading-out line 544 is connected with the fourth multiplexing control third leading-out line 554, so that the fourth multiplexing control third leading-out line 554 provides fourth multiplexing control signals to a plurality of multiplexing circuits 40 within a region on a right side of the first power supply line 311.

In some examples, the fifth multiplexing control third leading-out line 555 is connected with the fifth multiplexing control first leading-out line 535 through a via disposed in an insulation layer, so that the fifth multiplexing control third leading-out line 555 provides fifth multiplexing control signals to a plurality of multiplexing circuits 40 within a region on a right side of the first power supply line 311; and the fifth multiplexing control third leading-out line 555 is connected with the fifth multiplexing control second leading-out line 545, so that the fifth multiplexing control second leading-out line 545 provides fifth multiplexing control signals to a plurality of multiplexing circuits 40 within a region on a left side of the first power supply line 311.

In some examples, the sixth multiplexing control third leading-out line 556 is connected with the sixth multiplexing control first leading-out line 536 through a via disposed in an insulation layer, so that the sixth multiplexing control third leading-out line 556 provides sixth multiplexing control signals to a plurality of multiplexing circuits 40 within a region on a right side of the first power supply line 311; and the sixth multiplexing control third leading-out line 556 is connected with the sixth multiplexing control second leading-out line 546, so that the sixth multiplexing control second leading-out line 546 provides sixth multiplexing control signals to a plurality of multiplexing circuits 40 within a region on a left side of the first power supply line 311.

In some examples, the third multiplexing control third leading-out line 553 is connected with the third multiplexing control first leading-out line 533 through a via disposed in an insulation layer, so that the third multiplexing control third leading-out line 553 provides third multiplexing control signals to a plurality of multiplexing circuits 40 within a region on a right side of the first power supply line 311; and the third multiplexing control third leading-out line 553 is connected with the third multiplexing control second leading-out line 543, so that the third multiplexing control second leading-out line 543 provides third multiplexing control signals to a plurality of multiplexing circuits 40 within a region on a left side of the first power supply line 311.

In some examples, the second multiplexing control third leading-out line 552 is connected with the second multiplexing control first leading-out line 532 through a via disposed in an insulation layer, so that the second multiplexing control third leading-out line 552 provides second multiplexing control signals to a plurality of multiplexing circuits 40 within a region on a right side of the first power supply line 311; and the second multiplexing control third leading-out line 552 is connected with the second multiplexing control second leading-out line 542, so that the second multiplexing control second leading-out line 542 provides second multiplexing control signals to a plurality of multiplexing circuits 40 within a region on a left side of the first power supply line 311.

In some examples, the first multiplexing control third leading-out line 551 is connected with the first multiplexing control first leading-out line 531 through a via disposed in an insulation layer, so that the first multiplexing control third leading-out line 551 provides first multiplexing control signals to a plurality of multiplexing circuits 40 within a region on a right side of the first power supply line 311; and the first multiplexing control third leading-out line 551 is connected with the first multiplexing control second leading-out line 541, so that the first multiplexing control second leading-out line 541 provides first multiplexing control signals to a plurality of multiplexing circuits 40 within a region on a left side of the first power supply line 311.

A wiring mode of the first set of control leading-out lines 64a and the second set of control leading-out lines 64b within the first fanout region of the present example facilitates achievement of transmission of the first multiplexing control signals to the ninth multiplexing control signals to multiplexing circuits within regions on left and right sides of the first power supply line 311, which may save wiring space to facilitate narrowing of a bezel.

In some examples, as shown in FIG. 6, taking the ninth multiplexing control first leading-out line 539 as an example, the ninth multiplexing control first leading-out line 539 may be electrically connected with an electrostatic discharge circuit 41. The ninth multiplexing control first leading-out line 539 may include a trace located in the first gate metal layer and a trace located in the second gate metal layer, and the trace located in the first gate metal layer and the trace located in the second gate metal layer may be electrically connected through a connection electrode located in the first source-drain metal layer. Structures of remaining multiplexing control first leading-out lines are similar, and thus will not be repeated here.

In some examples, as shown in FIGs. 7 to 8C, active layers of nine multiplexing transistors of a multiplexing circuit are located in the semiconductor layer. An active layer of each multiplexing transistor may include a first region, a second region, and a channel region located between the first region and the second region. A first active layer M10 of a first multiplexing transistor M1, a second active layer M20 of a second multiplexing transistor M2, a third active layer M30 of a third multiplexing transistor M3, a fourth active layer M40 of a fourth multiplexing transistor M4, a fifth active layer M50 of a fifth multiplexing transistor M5, a sixth active layer M60 of a sixth multiplexing transistor M6, a seventh active layer M70 of a seventh multiplexing transistor M7, an eighth active layer M80 of an eighth multiplexing transistor M8, and a ninth active layer M90 of a ninth multiplexing transistor M9 may be sequentially arranged along the first direction X. Herein, the second active layer M20 and the third active layer M30 may be of an interconnected integral structure, the fifth active layer M50 and the sixth active layer M60 may be of an interconnected integral structure, and the eighth active layer M80 and the ninth active layer M90 may be of an interconnected integral structure, thereby reducing occupied space of the multiplexing circuit. However, the present embodiment is not limited thereto. For example, the active layers of the nine multiplexing transistors may be disposed independently.

In some examples, as shown in FIGs. 7 to 8C, gates of the nine multiplexing transistors of the multiplexing circuit may be located in the first gate metal layer. An orthographic projection of a gate of each multiplexing transistor on the base substrate may cover an orthographic projection of a channel region of a corresponding active layer on the base substrate. A gate M13 of the first multiplexing transistor M1, a gate M23 of the second multiplexing transistor M2, a gate M33 of the third multiplexing transistor M3, a gate M43 of the fourth multiplexing transistor M4, a gate M53 of the fifth multiplexing transistor M5, a gate M63 of the sixth multiplexing transistor M6, a gate M73 of the seventh multiplexing transistor M7, a gate M83 of the eighth multiplexing transistor M8, and a gate M93 of the ninth multiplexing transistor M9 may all extend along the second direction Y and be sequentially arranged along the first direction X.

In some examples, as shown in FIGs. 7 to 8C, first electrodes and second electrodes of the nine multiplexing transistors of the multiplexing circuit may be located in the first source-drain metal layer. A first electrode M11 of the first multiplexing transistor M1 may simultaneously serve as a first electrode of the second multiplexing transistor M2 and a first electrode of the third multiplexing transistor M3. The first electrode M11 of the first multiplexing transistor M1 may be connected with a first region of the first active layer M10 of the first multiplexing transistor M1, a first region of the second active layer M20 of the second multiplexing transistor M2, and a first region of the third active layer M30 of the third multiplexing transistor M3 through a plurality of vias opened in the interlayer dielectric layer, the second gate insulation layer, and the first gate insulation layer, and may also be electrically connected with a multiplexing data leading-out line 62 located in the first gate metal layer through vias opened in the interlayer dielectric layer and the second gate insulation layer.

In some examples, the second electrode M12 of the first multiplexing transistor M1 may be connected with a second region of the first active layer M10 of the first multiplexing transistor M1 through a plurality of vias opened in the interlayer dielectric layer, the second gate insulation layer, and the first gate insulation layer, and may also be electrically connected with a data fanout line 63 located in the first gate metal layer through vias opened in the interlayer dielectric layer and the second gate insulation layer. The second electrode M22 of the second multiplexing transistor M2 may be connected with a second region of the second active layer M20 of the second multiplexing transistor M2 through a plurality of vias opened in the interlayer dielectric layer, the second gate insulation layer, and the first gate insulation layer, and may also be electrically connected with a data fanout line 63 located in the second gate metal layer through a via opened in the interlayer dielectric layer. The second electrode M32 of the third multiplexing transistor M3 may be connected with a second region of the third active layer M30 through a plurality of vias opened in the interlayer dielectric layer, the second gate insulation layer, and the first gate insulation layer, and may also be electrically connected with a data fanout line 63 located in the first gate metal layer through vias opened in the interlayer dielectric layer and the second gate insulation layer.

In some examples, the first electrode M41 of the fourth multiplexing transistor M4 may simultaneously serve as a first electrode of the fifth multiplexing transistor M5 and a first electrode of the sixth multiplexing transistor M6. The first electrode M41 of the fourth multiplexing transistor M4 may be connected with a first region of the fourth active layer M40 of the fourth multiplexing transistor M4, a first region of the fifth active layer M50 of the fifth multiplexing transistor M5, and a first region of the sixth active layer M60 of the sixth multiplexing transistor M6 through a plurality of vias opened in the interlayer dielectric layer, the second gate insulation layer, and the first gate insulation layer, and may also be electrically connected with a multiplexing data leading-out line 62 located in the first gate metal layer through vias opened in the interlayer dielectric layer and the second gate insulation layer.

In some examples, the second electrode M42 of the fourth multiplexing transistor M4 may be connected with a second region of the fourth active layer M40 of the fourth multiplexing transistor M4 through a plurality of vias opened in the interlayer dielectric layer, the second gate insulation layer, and the first gate insulation layer, and may also be electrically connected with a data fanout line 63 located in the second gate metal layer through a via opened in the interlayer dielectric layer. The second electrode M52 of the fifth multiplexing transistor M5 may be connected with a second region of the fifth active layer M50 of the fifth multiplexing transistor M5 through a plurality of vias opened in the interlayer dielectric layer, the second gate insulation layer, and the first gate insulation layer, and may also be electrically connected with a data fanout line 63 located in the first gate metal layer through vias opened in the interlayer dielectric layer and the second gate insulation layer. The second electrode M62 of the sixth multiplexing transistor M6 may be connected with a second region of the sixth active layer M60 through a plurality of vias opened in the interlayer dielectric layer, the second gate insulation layer, and the first gate insulation layer, and may also be electrically connected with a data fanout line 63 located in the second gate metal layer through a via opened in the interlayer dielectric layer.

In some examples, the first electrode M71 of the seventh multiplexing transistor M7 may simultaneously serve as a first electrode of the eighth multiplexing transistor M8 and a first electrode of the ninth multiplexing transistor M9. The first electrode M71 of the seventh multiplexing transistor M7 may be connected with a first region of the seventh active layer M70 of the seventh multiplexing transistor M7, a first region of the eighth active layer M80 of the eighth multiplexing transistor M8, and a first region of the ninth active layer M90 of the ninth multiplexing transistor M9 through a plurality of vias opened in the interlayer dielectric layer, the second gate insulation layer, and the first gate insulation layer, and may also be electrically connected with a multiplexing data leading-out line 62 located in the first gate metal layer through vias opened in the interlayer dielectric layer and the second gate insulation layer.

In some examples, the second electrode M72 of the seventh multiplexing transistor M7 may be connected with a second region of the first active layer M70 of the seventh multiplexing transistor M7 through a plurality of vias opened in the interlayer dielectric layer, the second gate insulation layer, and the first gate insulation layer, and may also be electrically connected with a data fanout line 63 located in the first gate metal layer through vias opened in the interlayer dielectric layer and the second gate insulation layer. The second electrode M82 of the eighth multiplexing transistor M8 may be connected with a second region of the eighth active layer M80 of the eighth multiplexing transistor M8 through a plurality of vias opened in the interlayer dielectric layer, the second gate insulation layer, and the first gate insulation layer, and may also be electrically connected with a data fanout line 63 located in the second gate metal layer through a via opened in the interlayer dielectric layer. The second electrode M92 of the ninth multiplexing transistor M9 may be connected with a second region of the ninth active layer M90 through a plurality of vias opened in the interlayer dielectric layer, the second gate insulation layer, and the first gate insulation layer, and may also be electrically connected with a data fanout line 63 located in the first gate metal layer through vias opened in the interlayer dielectric layer and the second gate insulation layer.

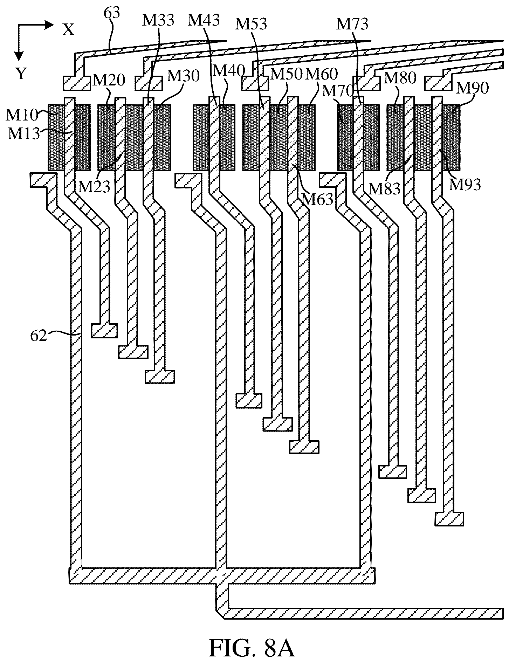

In some examples, as shown in FIGs. 7 to 8C, a plurality of data fanout lines 63 may be alternately disposed in the first gate metal layer and the second gate metal layer. A plurality of multiplexing data leading-out lines 62 may be alternately disposed in the first gate metal layer and the second gate metal layer. The present embodiment is not limited thereto.

In some examples, as shown in FIGs. 7 to 8C, the gate M13 of the first multiplexing transistor M1 may be electrically connected with the first multiplexing control second leading-out line 541 through a via opened in the interlayer dielectric layer and the second gate insulation layer. The gate M23 of the second multiplexing transistor M2 may be electrically connected with the second multiplexing control second leading-out line 542. The gate M33 of the third multiplexing transistor M3 may be electrically connected with the third multiplexing control second leading-out line 543. The gate M43 of the fourth multiplexing transistor M4 may be electrically connected with the fourth multiplexing control second leading-out line 544. The gate M53 of the fifth multiplexing transistor M5 may be electrically connected with the fifth multiplexing control second leading-out line 545. The gate M63 of the sixth multiplexing transistor M6 may be electrically connected with the sixth multiplexing control second leading-out line 546. The gate M73 of the seventh multiplexing transistor M7 may be electrically connected with the seventh multiplexing control second leading-out line 547. The gate M83 of the eighth multiplexing transistor M8 may be electrically connected with the eighth multiplexing control second leading-out line 548. The gate M93 of the ninth multiplexing transistor M9 may be electrically connected with the ninth multiplexing control second leading-out line 549.

In some examples, the ninth multiplexing control second leading-out line 549, the eighth multiplexing control second leading-out line 548, the seventh multiplexing control second leading-out line 547, the sixth multiplexing control second leading-out line 546, the fifth multiplexing control second leading-out line 545, the fourth multiplexing control second leading-out line 544, the third multiplexing control second leading-out line 543, the second multiplexing control second leading-out line 542, and the first multiplexing control second leading-out line 541 may be located in the first source-drain metal layer. A third low-voltage leading-out line 577, a second scan clock second leading-out line 834, a first scan clock second leading-out line 824, and a third high-voltage leading-out line 587 may be disposed on a side of a set of multiplexing control second leading-out lines 54 close to a multiplexing circuit; and the third low-voltage leading-out line 577, the second scan clock second leading-out line 834, the first scan clock second leading-out line 824, and the third high-voltage leading-out line 587 may be sequentially disposed along a direction away from the multiplexing circuit. A first scan output second leading-out line 844 may be disposed on a side of a set of multiplexing control second leading-out lines 54 away from the multiplexing circuit.

In some examples, the third low-voltage leading-out line 577 may be electrically connected with the first low-voltage leading-out line 575, and the third low-voltage leading-out line 577 may provide a first voltage signal to a gate drive circuit within a region of a left bezel. The third high-voltage leading-out line 587 may be electrically connected with the first high-voltage leading-out line, and the third high-voltage leading-out line 587 may provide a second voltage signal to the gate drive circuit within a region of the left bezel. The first scan clock second leading-out line 824 may be electrically connected with the first scan clock leading-out line 823, and the second scan clock second leading-out line 834 may be electrically connected with the second scan clock leading-out line 833. The first scan clock second leading-out line 824 and the second scan clock second leading-out line 834 may provide scan clock signals to the gate drive circuit. The first scan output second leading-out line 844 may be electrically connected with the first scan output leading-out line 843.

A structure of a multiplexing circuit disposed within a region on a right side of the first power supply line 311 is similar to that of a multiplexing circuit disposed within a region on a left side, and thus will not be repeated here. Herein, the multiplexing circuit within the region on the right side may be electrically connected with a set of multiplexing control third leading-out lines 55.

As shown in FIGs. 3 to 10, wiring of signal transmission within the first bezel region of this example may be shown in Table 1. Herein, a data signal may be provided by a first contact pad within the first signal access region B14, and a drive control signal, a first power supply signal, a second power supply signal, and a multiplexing control signal (including, for example, a first multiplexing control signal to a ninth multiplexing control signal) may be provided by a second contact pad within the second signal access region B15.

**Table 1**

| | Second fanout region | Bending region | First fanout region |
|---|---|---|---|
| Data signal | The first set of multiplexing data lines 61a and the second set of multiplexing data lines 61b | The first set of data bending connection lines 36a and the second set of data bending connection lines 36b | The first set of multiplexing data leading-out lines 62a and the second set of multiplexing data leading-out lines 62b are connected to the multiplexing circuit, and then are transmitted to a data line DL of the display region through a plurality of data fanout lines 63 |
| Drive control signal | The first set of drive control lines 81a are connected with the first set of drive control connection lines 82a, and the second set of drive control lines 81b are connected with the second set of drive control connection lines 82b | Part of traces within the first set of control bending connection lines 35a and the second set of control bending connection lines 35b | The first set of drive control leading-out lines 83a and the second set of drive control leading-out lines 83b, |
| First power supply signal | The first power supply leading-out line 312 | The first power supply connection line 31 | The first power supply line 311 |
| Second power supply signal | The second power supply leading-out lines 322a and 322b | The second power supply connection lines 32a and 32b | The second power supply lines 321a and 321b |
| Multiplexing control signal | The first set of multiplexing control lines 51a is connected with the first set of multiplexing control connection lines 52a, and the second set of multiplexing control lines 51b is connected with the second set of multiplexing control connection lines 52b | Part of traces within the first set of control bending connection lines 35a and the second set of control bending connection lines 35b | The first set of multiplexing control leading-out lines 53a is connected with a set of multiplexing control second leading-out lines 54, the second set of multiplexing control leading-out lines 53b is connected with a set of multiplexing control third leading-out lines 55, and the set of multiplexing control second leading-out lines 54 and the set of multiplexing control third leading-out lines 55 are connected to a plurality of multiplexing circuits |

In some examples, as shown in FIGs. 3 to 10, the ninth multiplexing control line 519, the ninth multiplexing control connection line 529, a control bending connection line, the ninth multiplexing control first leading-out line 539, the ninth multiplexing control second leading-out line 549, and the ninth multiplexing control third leading-out line 559 may be sequentially connected to achieve provision of ninth multiplexing control signals to a plurality of multiplexing circuits 40.

In some examples, the eighth multiplexing control line 518, the eighth multiplexing control connection line 528, a control bending connection line, the eighth multiplexing control first leading-out line 538, the eighth multiplexing control second leading-out line 548, and the eighth multiplexing control third leading-out line 558 may be sequentially connected to achieve provision of eighth multiplexing control signals to a plurality of multiplexing circuits 40.

In some examples, the seventh multiplexing control line 517, the seventh multiplexing control connection line 529, a control bending connection line, the seventh multiplexing control first leading-out line 537, the seventh multiplexing control second leading-out line 547, and the seventh multiplexing control third leading-out line 557 may be sequentially connected to achieve provision of seventh multiplexing control signals to a plurality of multiplexing circuits 40.

In some examples, the fourth multiplexing control line 514, the fourth multiplexing control connection line 524, a control bending connection line, the fourth multiplexing control first leading-out line 534, the fourth multiplexing control second leading-out line 544, and the fourth multiplexing control third leading-out line 554 may be sequentially connected to achieve provision of fourth multiplexing control signals to a plurality of multiplexing circuits 40.

In some examples, the sixth multiplexing control line 516, the sixth multiplexing control connection line 526, a control bending connection line, the sixth multiplexing control first leading-out line 536, the sixth multiplexing control third leading-out line 556, and the sixth multiplexing control second leading-out line 546 may be sequentially connected to achieve provision of sixth multiplexing control signals to a plurality of multiplexing circuits 40.

In some examples, the fifth multiplexing control line 515, the fifth multiplexing control connection line 525, a control bending connection line, the fifth multiplexing control first leading-out line 535, the fifth multiplexing control third leading-out line 555, and the fifth multiplexing control second leading-out line 545 may be sequentially connected to achieve provision of fifth multiplexing control signals to a plurality of multiplexing circuits 40.

In some examples, the third multiplexing control line 513, the third multiplexing control connection line 523, a control bending connection line, the third multiplexing control first leading-out line 533, the third multiplexing control third leading-out line 553, and the third multiplexing control second leading-out line 543 may be sequentially connected to achieve provision of third multiplexing control signals to a plurality of multiplexing circuits 40.

In some examples, the second multiplexing control line 512, the second multiplexing control connection line 522, a control bending connection line, the second multiplexing control first leading-out line 532, the second multiplexing control third leading-out line 552, and the second multiplexing control second leading-out line 542 may be sequentially connected to achieve provision of second multiplexing control signals to a plurality of multiplexing circuits 40.

In some examples, the first multiplexing control line 515, the first multiplexing control connection line 521, a control bending connection line, the first multiplexing control first leading-out line 531, the first multiplexing control third leading-out line 551, and the first multiplexing control second leading-out line 541 may be sequentially connected to achieve provision of first multiplexing control signals to a plurality of multiplexing circuits 40.

In some examples, the first set of multiplexing data lines 61a may be configured to provide data signals to sub-pixels in a left region of the display region, and the second set of multiplexing data lines 61b may be configured to provide data signals to sub-pixels in a right region of the display region. In this example, the first set of multiplexing data lines 61a are overlapped with four multiplexing control lines, and the second set of multiplexing data lines 61b are overlapped with five multiplexing control lines. Brightness data of the display region of the present example is shown in Table 2. A brightness difference rate in Table 2 may refer to a ratio of an absolute value of a brightness difference between the left region and the right region to brightness of the left region.

**Table 2**

| | Brightness of the left region (Unit: nit) | Brightness of the right region (Unit: nit) | Brightness difference rate |
|---|---|---|---|
| First set of first sub-pixels R1 | 0.29030 | 0.29047 | 0.058% |
| Second set of first sub-pixels R2 | 0.29040 | 0.29056 | 0.055% |
| Third set of first sub-pixels R3 | 0.29041 | 0.29057 | 0.055% |
| First set of second sub-pixels G1 | 0.88703 | 0.88723 | 0.023% |
| Second set of second sub-pixels G2 | 0.88726 | 0.88746 | 0.023% |
| Third set of second sub-pixels G3 | 0.88696 | 0.88715 | 0.021% |
| First set of third sub-pixels B1 | 0.11097 | 0.11103 | 0.054% |
| Second set of third sub-pixels B2 | 0.11099 | 0.11105 | 0.054% |
| Third set of third sub-pixels B3 | 0.11098 | 0.11104 | 0.054% |

As may be seen from Table 2, in the display panel of the present example, brightness differences between sub-pixels of a same color, which are controlled by a same reset control signal to supply data signals, in the left region and the right region of the display region are all less than 0.06%, and the brightness differences are invisible to naked eyes. Although the nine multiplexing control lines of the present example cannot be grouped equally and are wound from two opposite sides of the first signal access region, and a quantity of multiplexing control lines overlapped with the first set of multiplexing data lines 61a and a quantity of multiplexing control lines overlapped with the second set of multiplexing data lines 61b are different, through a grouping method of multiplexing control lines of the present example, it is possible to improve poor display such as split screen due to a signal load difference caused by overlapping of multiplexing data lines and multiplexing control lines.

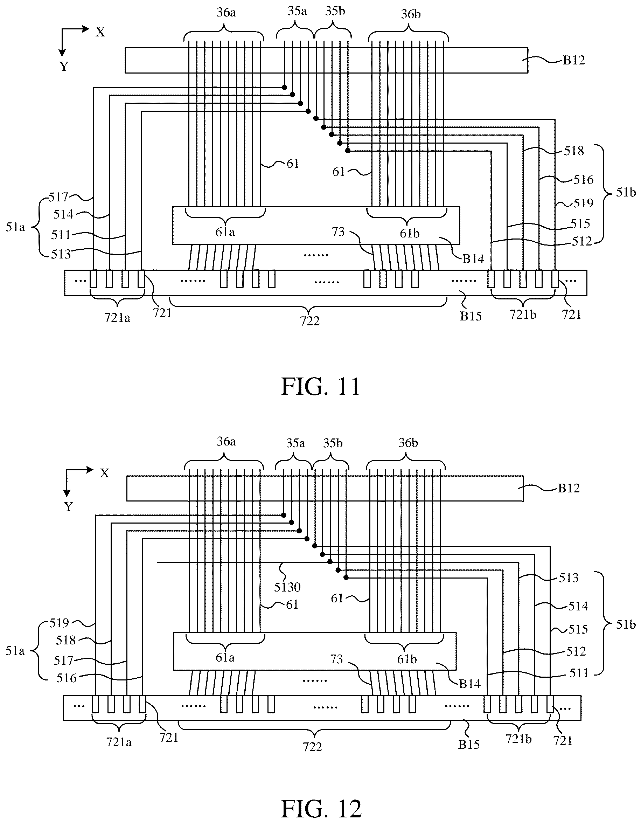

FIG. 11 is an exemplary diagram of another arrangement of a multiplexing control line and a multiplexing data line according to at least one embodiment of the present disclosure. FIG. 11 is illustrated by taking a case of only several multiplexing data lines as an example. In the present embodiment, a quantity of multiplexing data lines is not limited. This example is illustrated by taking a case in which a 1:9 design shown in FIG. 4 is adopted for a multiplexing circuit as an example.

In some examples, as shown in FIG. 11, the plurality of second contact pads within the second signal access region B15 may include a plurality of multiplexing control contact pads 721 and a set of middle contact pads 722. The plurality of multiplexing control contact pads 721 may include a first set of multiplexing control contact pads 721a and a second set of multiplexing control contact pads 721b. The first set of multiplexing control contact pads 721a and the second set of multiplexing control contact pads 721b may be located on two opposite sides of the set of middle contact pads 722 along the first direction X.

In some examples, in the nine multiplexing control lines, a multiplexing control line for controlling a multiplexing circuit to provide a data signal to a first sub-pixel emitting light of a first color (e.g., red light) may be a first-type multiplexing control line, a multiplexing control line for controlling a multiplexing circuit to provide a data signal to a second sub-pixel emitting light of a second color (e.g., green light) may be a second-type multiplexing control line, a multiplexing control line for controlling a multiplexing circuit to provide a data signal to a third sub-pixel emitting light of a third color (e.g., blue light) may be a third-type multiplexing control line. In this example, the first-type multiplexing control line may include a first multiplexing control line 511, a fourth multiplexing control line 514, and a seventh multiplexing control line 517; the second-type multiplexing control line may include a second multiplexing control line 512, a fifth multiplexing control line 515, and an eighth multiplexing control line 518; and the third-type multiplexing control line may include a third multiplexing control line 513, a sixth multiplexing control line 516, and a ninth multiplexing control line 519.

In some examples, as shown in FIG. 11, the nine multiplexing control lines may include a first set of multiplexing control lines 51a and a second set of multiplexing control lines 51b. The first set of multiplexing control lines 51a may include first-type multiplexing control lines (that is, including the seventh multiplexing control line 517, the fourth multiplexing control line 514, and the first multiplexing control line 511) and one third-type multiplexing control line (for example, the third multiplexing control line 513). The second set of multiplexing control lines 51b may include second-type multiplexing control lines (i.e., including the second multiplexing control line 512, the fifth multiplexing control line 515, and the eighth multiplexing control line 518) and remaining third-type multiplexing control lines (e.g., the sixth multiplexing control line 516 and the ninth multiplexing control line 519). However, the present embodiment is not limited thereto. In other examples, the first set of multiplexing control lines may include the first-type multiplexing control lines and two third-type multiplexing control lines; and the second set of multiplexing control lines may include the second-type multiplexing control lines and one third-type multiplexing control line. A division mode of third-type multiplexing control lines included in the first set of multiplexing control lines and the second set of multiplexing control lines is not limited.

In some examples, as shown in FIG. 11, the seventh multiplexing control line 517, the fourth multiplexing control line 514, the first multiplexing control line 511, and the third multiplexing control line 513 may be sequentially disposed along a direction close to the first signal access region B14. The second multiplexing control line 512, the fifth multiplexing control line 515, the eighth multiplexing control line 518, the sixth multiplexing control line 516, and the ninth multiplexing control line 519 may be sequentially disposed along a direction away from the first signal access region B14. However, an arrangement order of a plurality of multiplexing control lines within each set of multiplexing control lines is not limited in the present embodiment. In other examples, the third multiplexing control line 513, the seventh multiplexing control line 517, the fourth multiplexing control line 514, and the first multiplexing control line 511 may be sequentially disposed along a direction away from or close to the first signal access region. For another example, the sixth multiplexing control line 516 and the ninth multiplexing control line 519, the second multiplexing control line 512, the fifth multiplexing control line 515, and the eighth multiplexing control line 518 may be sequentially disposed along a direction away from or close to the first signal access region B14.

In some examples, as shown in FIG. 11, an orthographic projection of the first set of multiplexing control lines 51a on the base substrate may be overlapped with an orthographic projection of the first set of multiplexing data lines 61a on the base substrate, and not be overlapped with an orthographic projection of the second set of multiplexing data lines 61b on the base substrate. An orthographic projection of the second set of multiplexing control lines 51b on the base substrate may be overlapped with the orthographic projection of the second set of multiplexing data lines 61b on the base substrate, and not be overlapped with the orthographic projection of the first set of multiplexing data lines 61a on the base substrate. An orthographic projection of each multiplexing data line of the first set of multiplexing data lines 61a on the base substrate is overlapped with orthographic projections of four multiplexing control lines on the base substrate, and an orthographic projection of each multiplexing data line of the second set of multiplexing data lines 61b on the base substrate is overlapped with orthographic projections of five multiplexing control lines on the base substrate.

In some examples, within the second fanout region, by adopting a symmetrical wiring design for the first-type multiplex control line for controlling to provide the data signal to the first sub-pixel and the second-type multiplex control line for controlling to provide the data signal to the second sub-pixel (e.g., the first type multiplexing control line and the second-type multiplexing control line may be wound from two opposite sides of the first signal access region, respectively, so that quantities of multiplexing control lines wound from two opposite sides of the first signal access region are the same), uniformity of red light emitted by the first sub-pixel and green light emitted by the second sub-pixel may be ensured. Since human eyes are least sensitive to blue light emitted by the third sub-pixel, by adopting an asymmetric wiring design for the third-type multiplexing control line for controlling to provide the data signal to the third sub-pixel (e.g., there is a difference in quantities of third-type multiplexing control lines wound from the two opposite sides of the first signal access region, one third-type multiplexing control line is wound from a left side of the first signal access region, and two third-type multiplexing control lines are wound from a right side of the first signal access region, so that quantities of multiplexing control lines arranged on the two opposite sides of the first signal access region are inconsistent), local display difference of blue light emitted by the third sub-pixel may be made indistinguishable to naked eyes, and a display effect may be guaranteed. Asymmetric wiring of multiplexing control lines in the present example means that quantities of multiplexing control lines arranged on the two opposite sides of the first signal access region are inconsistent, and symmetric wiring means that quantities of multiplexing control lines arranged on the two opposite sides of the first signal access region are consistent. An arrangement mode of nine multiplexing control lines adopted in this example may improve local display difference in the display region led by a signal load difference caused by overlapping of multiplexing control lines and multiplexing data lines due to an asymmetric design for odd-number multiplexing control lines, and further improve a display effect.

Rest of a structure of the display panel of the example may be referred to description of the aforementioned embodiments, and thus will not be repeated here.

FIG. 12 is an exemplary diagram of another arrangement of a multiplexing control line and a multiplexing data line according to at least one embodiment of the present disclosure. FIG. 12 is illustrated by taking a case of only several multiplexing data lines as an example. In the present embodiment, a quantity of multiplexing data lines is not limited. This example is illustrated by taking a case in which a 1:9 design shown in FIG. 4 is adopted for a multiplexing circuit as an example.

In some examples, as shown in FIG. 12, the nine multiplexing control lines may include a first set of multiplexing control lines 51a and a second set of multiplexing control lines 51b. The first set of multiplexing control lines 51a may include following four multiplexing control lines: a ninth multiplexing control line 519, an eighth multiplexing control line 518, a seventh multiplexing control line 517, and a sixth multiplexing control line 516. The second set of multiplexing control lines 51b may include following five multiplexing control lines: a first multiplexing control line 511, a second multiplexing control line 512, a third multiplexing control line 513, a fourth multiplexing control line 514, and a fifth multiplexing control line 515. Herein, the third multiplexing control line 513 for controlling a multiplexing circuit to give the third sub-pixel emitting the light of the third color may have an extension line 5130. The extension line 5130 of the third multiplexing control line 513 may extend towards a direction of the first set of multiplexing data lines 61a along the first direction X.

In some examples, as shown in FIG. 12, in the first set of multiplexing control lines 51a, the ninth multiplexing control line 519, the eighth multiplexing control line 518, the seventh multiplexing control line 517, and the sixth multiplexing control line 516 may be sequentially disposed along a direction close to the first signal access region B14. However, an arrangement order of the four multiplexing control lines within the first set of multiplexing control lines 51a is not limited in the present embodiment. In other examples, the ninth multiplexing control line 519, the eighth multiplexing control line 518, the seventh multiplexing control line 517, and the sixth multiplexing control line 516 may be sequentially disposed along a direction away from the first signal access region B14. For another example, the sixth multiplexing control line 516, the ninth multiplexing control line 519, the eighth multiplexing control line 518, and the seventh multiplexing control line 517 may be sequentially disposed along a direction away from or close to the first signal access region B14.

In some examples, as shown in FIG. 12, in the second set of multiplexing control lines 51b, the first multiplexing control line 511, the second multiplexing control line 512, the third multiplexing control line 513, the fourth multiplexing control line 514, and the fifth multiplexing control line 515 may be sequentially disposed along a direction away from the first signal access region B14. However, an arrangement order of the five multiplexing control lines within the second set of multiplexing control lines 51b is not limited in the present embodiment. In other examples, the first multiplexing control line 511, the second multiplexing control line 512, the third multiplexing control line 513, the fourth multiplexing control line 514, and the fifth multiplexing control line 515 may be sequentially disposed along a direction away from the first signal access region B14. For another example, the fourth multiplexing control line 514, the fifth multiplexing control line 515, the first multiplexing control line 511, the second multiplexing control line 512, and the third multiplexing control line 513 may be sequentially disposed along a direction away from or close to the first signal access region B14.

In some examples, as shown in FIG. 12, an orthographic projection of the first set of multiplexing control lines 51a on the base substrate may be overlapped with an orthographic projection of the first set of multiplexing data lines 61a on the base substrate, and not be overlapped with an orthographic projection of the second set of multiplexing data lines 61b on the base substrate. An orthographic projection of the second set of multiplexing control lines 51b on the base substrate may be overlapped with the orthographic projection of the second set of multiplexing data lines 61b on the base substrate, and not be overlapped with the orthographic projection of the first set of multiplexing data lines 61a on the base substrate. An orthographic projection of the extension line 5130 of the third multiplexing control line 513 in the second set of multiplexing control lines 51b on the base substrate is overlapped with the orthographic projection of the first set of multiplexing data lines 61a on the base substrate.

In the present example, an orthographic projection of each multiplexing data line in the first set of multiplexing data lines 61a on the base substrate may be overlapped orthographic projections of four multiplexing control lines in the first set of multiplexing control lines 51a and the extension line 5130 of the third multiplexing control line 513 on the base substrate, that is, the orthographic projection of each multiplexing data line in the first set of multiplexing data lines 61a on the base substrate is overlapped with orthographic projections of five multiplexing control lines on the base substrate. An orthographic projection of each multiplexing data line in the second set of multiplexing data lines 61b on the base substrate is overlapped with orthographic projections of five multiplexing control lines in the second set of multiplexing control lines 51b on the base substrate. In this example, an orthographic projection of each multiplexing data line on the base substrate is overlapped with orthographic projections of a same quantity (e.g., five) of multiplexing control lines on the base substrate.

In this example, by setting an extension line of a multiplexing control line to be overlapped with a multiplexing data lines, overlapping of a plurality of multiplexing data lines with a same quantity of multiplexing control lines may be ensured, thereby improving local display difference of the display region (for example, there are display differences on left and right sides of the display region) led by signal load differences caused by inconsistency of overlapping capacitances of a plurality of multiplexing data lines and a plurality of multiplexing control lines due to a fact that odd multiplexing control lines cannot be equally divided, thereby improving a display effect. Since the human eyes are least sensitive to blue light emitted by the third sub-pixel, by performing an extension design on the third multiplexing control line for controlling to provide a data signal to the third sub-pixel, local display difference of the blue light emitted by the third sub-pixel may be made indistinguishable to naked eyes, and poor display caused by data signal load differences may be improved.

Rest of a structure of the display panel of the example may be referred to description of the aforementioned embodiments, and thus will not be repeated here.

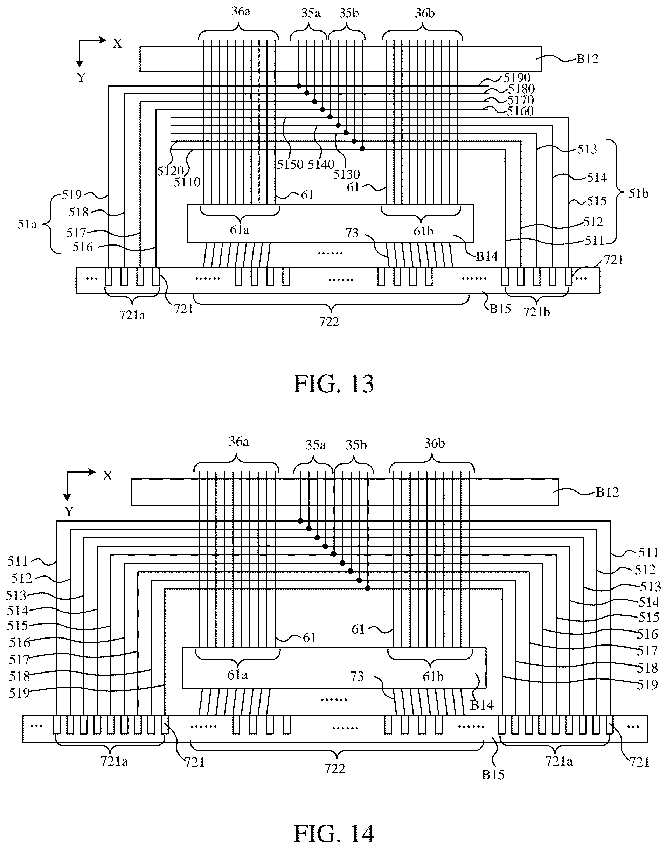

FIG. 13 is an exemplary diagram of another arrangement of a multiplexing control line and a multiplexing data line according to at least one embodiment of the present disclosure. FIG. 13 is illustrated by taking a case of only several multiplexing data lines as an example. In the present embodiment, a quantity of multiplexing data lines is not limited. This example is illustrated by taking a case in which a 1:9 design shown in FIG. 4 is adopted for a multiplexing circuit as an example. In the present example, a quantity of multiplexing control lines is not limited, and for example, a quantity of multiplexing control lines may be another odd number.

In some examples, as shown in FIG. 13, nine multiplexing control lines may include a first set of multiplexing control lines 51a and a second set of multiplexing control lines 51b. The first set of multiplexing control lines 51a may include following four multiplexing control lines: a ninth multiplexing control line 519, an eighth multiplexing control line 518, a seventh multiplexing control line 517, and a sixth multiplexing control line 516. The second set of multiplexing control lines 51b may include following five multiplexing control lines: a first multiplexing control line 511, a second multiplexing control line 512, a third multiplexing control line 513, a fourth multiplexing control line 514, and a fifth multiplexing control line 515. Herein, each multiplexing control line has an extension line. For example, an extension line 5110 of the first multiplexing control line 511 may extend towards a direction of the first set of multiplexing data lines 61a along the first direction X; an extension line 5120 of the second multiplexing control line 512 may extend towards the direction of the first set of multiplexing data lines 61a along the first direction X; an extension line 5130 of the third multiplexing control line 513 may extend towards the direction of the first set of multiplexing data lines 61a along the first direction X; an extension line 5140 of the fourth multiplexing control line 514 may extend towards the direction of the first set of multiplexing data lines 61a along the first direction X; an extension line 5150 of the fifth multiplexing control line 515 may extend towards the direction of the first set of multiplexing data lines 61a along the first direction X; an extension line 5160 of the sixth multiplexing control line 516 may extend towards a direction of the second set of multiplexing data lines 61b along the first direction X; an extension line 5170 of the seventh multiplexing control line 517 may extend towards the direction of the second set of multiplexing data lines 61b along the first direction X; an extension line 5180 of the eighth multiplexing control line 518 may extend towards the direction of the second set of multiplexing data lines 61b along the first direction X; and an extension line 5190 of the ninth multiplexing control line 519 may extend towards the direction of the second set of multiplexing data lines 61b along the first direction X. Extension lines of the first set of multiplexing control lines 51a may be located on a side of the second set of multiplexing control lines close to the display region, and extension lines of the second set of multiplexing control lines 51b may be located on a side of the first set of multiplexing control lines away from the display region.

In some examples, as shown in FIG. 13, in the first set of multiplexing control lines 51a, the ninth multiplexing control line 519, the eighth multiplexing control line 518, the seventh multiplexing control line 517, and the sixth multiplexing control line 516 may be sequentially disposed along a direction close to the first signal access region B14. An orthographic projection of the first set of multiplexing control lines 51a on the base substrate may be overlapped with an orthographic projection of the first set of multiplexing data lines 61a on the base substrate, and an orthographic projection of an extension line of each multiplexing control line in the first set of multiplexing control lines 51a on the base substrate may be overlapped with an orthographic projection of the second set of multiplexing data lines 61b on the base substrate. In the present embodiment, an arrangement order of a plurality of multiplexing control lines in the first set of multiplexing control lines 51a is not limited. For example, the ninth multiplexing control line 519, the eighth multiplexing control line 518, the seventh multiplexing control line 517, and the sixth multiplexing control line 516 may be sequentially disposed along a direction away from the first signal access region B14.

In some examples, as shown in FIG. 13, in the second set of multiplexing control lines 51b, the first multiplexing control line 511, the second multiplexing control line 512, the third multiplexing control line 513, the fourth multiplexing control line 514, and the fifth multiplexing control line 515 may be sequentially disposed along a direction away from the first signal access region B14. An orthographic projection of the second set of multiplexing control lines 51b on the base substrate may be overlapped with an orthographic projection of the second set of multiplexing data lines 61b on the base substrate, and an orthographic projection of an extension line of each multiplexing control line in the second set of multiplexing control lines 51b on the base substrate is overlapped with an orthographic projection of the first set of multiplexing data lines 61a on the base substrate. In the present embodiment, an arrangement order of a plurality of multiplexing control lines in the second set of multiplexing control lines 51b is not limited. For example, the first multiplexing control line 511, the second multiplexing control line 512, the third multiplexing control line 513, the fourth multiplexing control line 514, and the fifth multiplexing control line 515 may be sequentially disposed along a direction close to the first signal access region B14. In other examples, the first set of multiplexing control lines 51a may include five multiplexing control lines, and the second set of multiplexing control lines 51b may include four multiplexing control lines. In the present embodiment, an arrangement order of a plurality of multiplexing control lines in each set of multiplexing control lines is not limited.

In some examples, lengths of the nine multiplexing control lines (including lengths of extension lines) may be approximately the same to ensure consistency of trace capacitances of the multiplexing control lines. Each multiplexing control line is overlapped with the first set of multiplexing data lines 61a and the second set of multiplexing data lines 61b, which may ensure consistency of overlapping capacitances between different multiplexing control lines and multiplexing data lines, thereby improving poor display caused by inconsistency of overlapping capacitances between multiplexing control lines and multiplexing data lines, and improving a display effect.

Rest of a structure of the display panel of the example may be referred to description of the aforementioned embodiments, and thus will not be repeated here.

FIG. 14 is an exemplary diagram of another arrangement of a multiplexing control line and a multiplexing data line according to at least one embodiment of the present disclosure. FIG. 14 is illustrated by taking a case of only several multiplexing data lines as an example. In the present embodiment, a quantity of multiplexing data lines is not limited. This example is illustrated by taking a case in which a 1:9 design shown in FIG. 4 is adopted for a multiplexing circuit as an example. In the present example, a quantity of multiplexing control lines is not limited, and for example, a quantity of multiplexing control lines may be another odd number.

In some examples, as shown in FIG. 14, a first end of each multiplexing control line of the nine multiplexing control lines may be connected with at least one multiplexing control contact pad 721 in the first set of multiplexing control contact pads 721a, and a second end may be connected with at least one multiplexing control contact pad 721 in the second set of multiplexing control contact pads 721b. Each multiplexing control line may bypass the first signal access region B14 from a side of the first signal access region B14 close to the display region. In the nine multiplexing control lines, the first multiplexing control line 511, the second multiplexing control line 512, the third multiplexing control line 513, the fourth multiplexing control line 514, the fifth multiplexing control line 515, the sixth multiplexing control line 516, the seventh multiplexing control line 517, the eighth multiplexing control line 518, and the ninth multiplexing control line 519 may be sequentially disposed along a direction close to the first signal access region B14. However, in the present embodiment, an arrangement order of the nine multiplexing control lines is not limited. For example, the first multiplexing control line 511, the second multiplexing control line 512, the third multiplexing control line 513, the fourth multiplexing control line 514, the fifth multiplexing control line 515, the sixth multiplexing control line 516, the seventh multiplexing control line 517, the eighth multiplexing control line 518, and the ninth multiplexing control line 519 may be sequentially disposed along a direction away from the first signal access region B14.

In some examples, as shown in FIG. 14, the first set of multiplexing data lines 61a may be overlapped with nine multiplexing control lines, and the second set of multiplexing data lines 61b may be overlapped with the nine multiplexing control lines. The nine multiplexing control lines may be connected with a first set of multiplexing control connection lines (a first set of multiplexing control connection lines 52a as shown in FIG. 5) and a second set of multiplexing control connection lines (a second set of multiplexing control connection lines 52b as shown in FIG. 5) within an interval region between the first set of multiplexing data lines 61a and the second set of multiplexing data lines 61b, and are connected with part of control bending connection lines in the first set of control bending connection lines 35a and the second set of control bending connection lines 35b within the bending region B12 through the first set of multiplexing control connection lines and the second set of multiplexing control connection lines.

In this example, by setting each multiplexing control line to be overlapped with the first set of multiplexing data lines 61a and the second set of multiplexing data lines 61b, consistency of overlapping capacitances between different multiplexing control lines and multiplexing data lines may be ensured, thereby improving poor display caused by inconsistency of overlapping capacitances between multiplexing control lines and multiplexing data lines, and improving a display effect.

Rest of a structure of the display panel of the example may be referred to description of the aforementioned embodiments, and thus will not be repeated here.

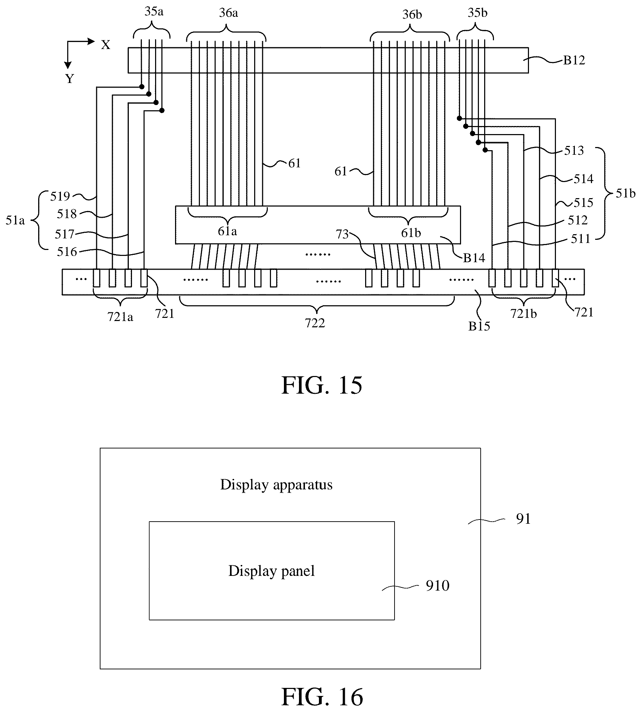

FIG. 15 is an exemplary diagram of another arrangement of a multiplexing control line and a multiplexing data line according to at least one embodiment of the present disclosure. FIG. 15 is illustrated by taking a case of only several multiplexing data lines as an example. In the present embodiment, a quantity of multiplexing data lines is not limited. This example is illustrated by taking a case in which a 1:9 design shown in FIG. 4 is adopted for a multiplexing circuit as an example. In the present example, a quantity of multiplexing control lines is not limited, and for example, a quantity of multiplexing control lines may be another odd number.

In some examples, as shown in FIG. 15, orthographic projections of the nine multiplexing control lines on the base substrate may not be overlapped with orthographic projections of a plurality of multiplexing data lines on the base substrate. The nine multiplexing control lines may include a first set of multiplexing control lines 51a and a second set of multiplexing control lines 51b. The first set of multiplexing control lines 51a may include following four multiplexing control lines: a ninth multiplexing control line 519, an eighth multiplexing control line 518, a seventh multiplexing control line 517, and a sixth multiplexing control line 516. The second set of multiplexing control lines 51b may include following five multiplexing control lines: a first multiplexing control line 511, a second multiplexing control line 512, a third multiplexing control line 513, a fourth multiplexing control line 514, and a fifth multiplexing control line 515. The first set of multiplexing control lines may be located on a side of the first set of multiplexing data lines 61a away from the second set of multiplexing data lines 61b, and the second set of multiplexing control lines may be located on a side of the second set of multiplexing data lines 61b away from the first set of multiplexing data lines 61a.

In some examples, as shown in FIG. 15, in the first set of multiplexing control lines 51a, the ninth multiplexing control line 519, the eighth multiplexing control line 518, the seventh multiplexing control line 517, and the sixth multiplexing control line 516 may be sequentially disposed along a direction close to the first signal access region B14. In the present embodiment, an arrangement order of a plurality of multiplexing control lines in the first set of multiplexing control lines 51a is not limited. For example, the ninth multiplexing control line 519, the eighth multiplexing control line 518, the seventh multiplexing control line 517, and the sixth multiplexing control line 516 may be sequentially disposed along a direction away from the first signal access region B14.

In some examples, as shown in FIG. 15, in the second set of multiplexing control lines 51b, the first multiplexing control line 511, the second multiplexing control line 512, the third multiplexing control line 513, the fourth multiplexing control line 514, and the fifth multiplexing control line 515 may be sequentially disposed along a direction away from the first signal access region B14. In the present embodiment, an arrangement order of a plurality of multiplexing control lines in the second set of multiplexing control lines 51b is not limited. For example, the first multiplexing control line 511, the second multiplexing control line 512, the third multiplexing control line 513, the fourth multiplexing control line 514, and the fifth multiplexing control line 515 may be sequentially disposed along a direction close to the first signal access region B14. In other examples, the first set of multiplexing control lines 51a may include five multiplexing control lines, and the second set of multiplexing control lines 51b may include four multiplexing control lines.

In some examples, as shown in FIG. 15, within the bending region B12, the first set of control bending connection lines 35a connected with the first set of multiplexing control lines 51a may be located on a side of the first set of data bending connection lines 36a close to an edge of the display panel. The second set of control bending connection lines 35b connected with the second set of multiplexing control lines 51b may be located on a side of the second set of data bending connection lines 36b close to the edge of the display panel.

In the present example, by setting a plurality of multiplexing control lines not to be overlapped with a plurality of multiplexing data lines so as to avoid a capacitance generated by overlapping of a plurality of multiplexing control lines with a plurality of multiplexing data lines, a signal load differences caused by inconsistence of overlapping capacitances may be avoided and a display effect may be improved.

Rest of a structure of the display panel of the example may be referred to description of the aforementioned embodiments, and thus will not be repeated here.

An embodiment also provides a display panel, including a base substrate, a plurality of sub-pixels, a plurality of data lines, a plurality of multiplexing circuits, a plurality of multiplexing data lines, and N multiplexing control lines. The base substrate includes a display region and a first bezel region located on at least one side of the display region. The plurality of sub-pixels and the plurality of data lines are located in the display region, wherein the plurality of data lines are connected with the plurality of sub-pixels and configured to provide data signals to the plurality of sub-pixels. The plurality of multiplexing circuits, the plurality of multiplexing data lines, and the N multiplexing control lines are located in the first bezel region, wherein N is equal to 2n+1, and n is an integer greater than 0. At least one multiplexing circuit of the plurality of multiplexing circuits is electrically connected with the N multiplexing control lines, one multiplexing data line, and a plurality of data lines, and is configured to provide a data signal transmitted by the multiplexing data line to the plurality of data lines under control of the N multiplexing control lines. At least part of line segments of each multiplexing data line of the plurality of multiplexing data lines extend along a first direction and at least part of line segments of each multiplexing control line of the N multiplexing control lines extend along a second direction. At least part of line segments of the multiplexing data line intersect with at least part of line segments of the multiplexing control line. For example, the second multiplexing extension segment or the fourth multiplexing extension segment of the multiplexing control line of the foregoing embodiment may intersect with the multiplexing data line.

In some exemplary implementation modes, at least part of line segments of the multiplexing control lines and at least part of line segments of the plurality of multiplexing data lines have a same intersection angle.

In some exemplary implementation modes, an intersection angle between at least part of line segments of the multiplexing control line and at least part of line segments of the multiplexing data line is less than or equal to 90 degrees. For example, a clockwise intersection angle between at least part of line segments of the multiplexing control line and at least part of line segments of the multiplexing data line may be less than or equal to 90 degrees.

In some exemplary implementation modes, a value of N is 9.

Rest of description of the display panel of the example may be referred to description of the aforementioned embodiments, and thus will not be repeated here.

FIG. 16 is a schematic diagram of a display apparatus according to at least one embodiment of the present disclosure. As shown in FIG. 16, the embodiment provides a display apparatus 91 including a display panel 910 of the aforementioned embodiments. In some examples, the display panel 910 may be an OLED display panel, such as an OLED display panel with an integrated touch structure. The display apparatus 91 may be any product or component having a display function, such as a mobile phone, a tablet computer, a television, a display, a notebook computer, a digital photo frame, or a navigator, or may be a product or component having touch and display functions.

In some examples, the display apparatus 91 may be a wearable display apparatus, for example, which may be worn on a human body in some manners. For example, the display apparatus 91 may be a smart watch, a smart bracelet, and the like. However, the present embodiment is not limited thereto.

The drawings of the present disclosure only involve structures involved in the present disclosure, and other structures may be referred to conventional designs. The embodiments of the present disclosure, i.e., features in the embodiments, may be combined with each other to obtain new embodiments if there is no conflict. Those of ordinary skills in the art should understand that modifications or equivalent replacements may be made to the technical solutions of the present disclosure without departing from the essence and scope of the technical solutions of the present disclosure, and shall all fall within the scope of the claims of the present disclosure.

## Claims

1. A display panel, comprising:
a base substrate, comprising a display region and a first bezel region located on at least one side of the display region;
a plurality of sub-pixels and a plurality of data lines located in the display region, wherein the plurality of data lines are connected with the plurality of sub-pixels and configured to provide data signals to the plurality of sub-pixels; and
a plurality of multiplexing circuits, a plurality of multiplexing data lines, and N multiplexing control lines which are located in the first bezel region, wherein N is equal to 2n+1, and n is an integer greater than 0;
wherein at least one multiplexing circuit of the plurality of multiplexing circuits is electrically connected with the N multiplexing control lines, one multiplexing data line, and a plurality of data lines, and is configured to provide a data signal transmitted by the multiplexing data line to the plurality of data lines under control of the N multiplexing control lines; and
an orthographic projection of each multiplexing data line of the plurality of multiplexing data lines on the base substrate is overlapped with orthographic projections of at least n multiplexing control lines on the base substrate, or orthographic projections of the plurality of multiplexing data lines on the base substrate are not overlapped with orthographic projections of the N multiplexing control lines on the base substrate.

2. The display panel according to claim 1, wherein the N multiplexing control lines comprise a first set of multiplexing control lines and a second set of multiplexing control lines, wherein the first set of multiplexing control lines comprises n multiplexing control lines, and the second set of multiplexing control lines comprises n+1 multiplexing control lines; and
the plurality of multiplexing data lines comprise a first set of multiplexing data lines and a second set of multiplexing data lines, wherein an orthographic projection of each multiplexing data line in the first set of multiplexing data lines on the base substrate is overlapped with orthographic projections of n multiplexing control lines in the first set of multiplexing control lines on the base substrate, and each multiplexing data line in the second set of multiplexing data lines is overlapped with n+1 multiplexing control lines in the second set of multiplexing control lines.

3. The display panel according to claim 2, wherein the plurality of sub-pixels comprise a first sub-pixel emitting light of a first color, a second sub-pixel emitting light of a second color, and a third sub-pixel emitting light of a third color; at least one of the N multiplexing control lines is configured to control the multiplexing circuit to provide data signals to a plurality of first sub-pixels through the data lines, at least one of the N multiplexing control lines is configured to control the multiplexing circuit to provide data signals to a plurality of second sub-pixels through the data lines, and at least one of the N multiplexing control lines is configured to control the multiplexing circuit to provide data signals to a plurality of third sub-pixels through the data lines.

4. The display panel according to claim 3, wherein a value of n is 4.

5. The display panel according to claim 4, wherein the N multiplexing control lines comprise a first multiplexing control line, a second multiplexing control line, a third multiplexing control line, a fourth multiplexing control line, a fifth multiplexing control line, a sixth multiplexing control line, a seventh multiplexing control line, an eighth multiplexing control line, and a ninth multiplexing control line;
the plurality of sub-pixels comprise a first set of sub-pixels, a second set of sub-pixels, and a third set of sub-pixels, wherein the first set of sub-pixels comprises a first set of first sub-pixels, a first set of second sub-pixels, and a first set of third sub-pixels, the second set of sub-pixels comprises a second set of first sub-pixels, a second set of second sub-pixels, and a second set of third sub-pixels, and the third set of sub-pixels comprises a third set of first sub-pixels, a third set of second sub-pixels, and a third set of third sub-pixels;
the first multiplexing control line is configured to control the multiplexing circuit to provide data signals to the first set of first sub-pixels;
the second multiplexing control line is configured to control the multiplexing circuit to provide data signals to the first set of second sub-pixels;
the third multiplexing control line is configured to control the multiplexing circuit to provide data signals to the first set of third sub-pixels;
the fourth multiplexing control line is configured to control the multiplexing circuit to provide data signals to the second set of first sub-pixels;
the fifth multiplexing control line is configured to control the multiplexing circuit to provide data signals to the second set of second sub-pixels;
the sixth multiplexing control line is configured to control the multiplexing circuit to provide data signals to the second set of third sub-pixels;
the seventh multiplexing control line is configured to control the multiplexing circuit to provide data signals to the third set of first sub-pixels;
the eighth multiplexing control line is configured to control the multiplexing circuit to provide data signals to the third set of second sub-pixels;
the ninth multiplexing control line is configured to control the multiplexing circuit to provide data signals to the third set of third sub-pixels;
the first set of multiplexing control lines comprises a fourth multiplexing control line, a seventh multiplexing control line, an eighth multiplexing control line, and a ninth multiplexing control line; and
the second set of multiplexing control lines comprises a first multiplexing control line, a second multiplexing control line, a third multiplexing control line, a sixth multiplexing control line, and a fifth multiplexing control line.

6. The display panel according to claim 5, wherein in the first set of multiplexing control lines, the fourth multiplexing control line, the seventh multiplexing control line, the eighth multiplexing control line, and the ninth multiplexing control line are sequentially arranged along a direction away from the second set of multiplexing data lines; and
in the second set of multiplexing control lines, the first multiplexing control line, the second multiplexing control line, the third multiplexing control line, the sixth multiplexing control line, and the fifth multiplexing control line are sequentially arranged along a direction away from the first set of multiplexing data lines.

7. The display panel according to claim 3, wherein in the N multiplexing control lines, a multiplexing control line for controlling the multiplexing circuit to provide data signals to the first sub-pixels is a first-type multiplexing control line, a multiplexing control line for controlling the multiplexing circuit to provide data signals to the second sub-pixels is a second-type multiplexing control line, and a multiplexing control line for controlling the multiplexing circuit to provide data signals to the third sub-pixels is a third-type multiplexing control line;
the first set of multiplexing control lines comprises: the first-type multiplexing control line and at least one third-type multiplexing control line; and
the second set of multiplexing control lines comprises the third-type multiplexing control line and remaining third-type multiplexing control lines.

8. The display panel according to claim 7, wherein the N multiplexing control lines comprise a first multiplexing control line, a second multiplexing control line, a third multiplexing control line, a fourth multiplexing control line, a fifth multiplexing control line, a sixth multiplexing control line, a seventh multiplexing control line, an eighth multiplexing control line, and a ninth multiplexing control line;
the plurality of sub-pixels comprise a first set of sub-pixels, a second set of sub-pixels, and a third set of sub-pixels, wherein the first set of sub-pixels comprises a first set of first sub-pixels, a first set of second sub-pixels, and a first set of third sub-pixels, the second set of sub-pixels comprises a second set of first sub-pixels, a second set of second sub-pixels, and a second set of third sub-pixels, and the third set of sub-pixels comprises a third set of first sub-pixels, a third set of second sub-pixels, and a third set of third sub-pixels;
the first multiplexing control line is configured to control the multiplexing circuit to provide data signals to the first set of first sub-pixels;
the second multiplexing control line is configured to control the multiplexing circuit to provide data signals to the first set of second sub-pixels;
the third multiplexing control line is configured to control the multiplexing circuit to provide data signals to the first set of third sub-pixels;
the fourth multiplexing control line is configured to control the multiplexing circuit to provide data signals to the second set of first sub-pixels;
the fifth multiplexing control line is configured to control the multiplexing circuit to provide data signals to the second set of second sub-pixels;
the sixth multiplexing control line is configured to control the multiplexing circuit to provide data signals to the second set of third sub-pixels;
the seventh multiplexing control line is configured to control the multiplexing circuit to provide data signals to the third set of first sub-pixels;
the eighth multiplexing control line is configured to control the multiplexing circuit to provide data signals to the third set of second sub-pixels;
the ninth multiplexing control line is configured to control the multiplexing circuit to provide data signals to the third set of third sub-pixels;
the first set of multiplexing control lines comprises a first multiplexing control line, a fourth multiplexing control line, a seventh multiplexing control line, and a third multiplexing control line; and
the second set of multiplexing control lines comprises a second multiplexing control line, a fifth multiplexing control line, an eighth multiplexing control line, a sixth multiplexing control line, and a ninth multiplexing control line.

9. The display panel according to claim 1, wherein the plurality of multiplexing data lines comprise a first set of multiplexing data lines and a second set of multiplexing data lines, and a quantity of multiplexing control lines overlapped with each multiplexing data line of the first set of multiplexing data lines is the same as a quantity of multiplexing control lines overlapped with each multiplexing data line of the second set of multiplexing data lines.

10. The display panel according to claim 9, wherein the N multiplexing control lines comprise a first set of multiplexing control lines and a second set of multiplexing control lines, wherein the first set of multiplexing control lines comprises n multiplexing control lines, and the second set of multiplexing control lines comprises n+1 multiplexing control lines; and
an orthographic projection of each multiplexing data line in the first set of multiplexing data lines on the base substrate is overlapped with orthographic projections of n multiplexing control lines in the first set of multiplexing control lines and an extension line of one multiplexing control line in the second set of multiplexing control lines on the base substrate, and an orthographic projection of each multiplexing data line in the second set of multiplexing data lines on the base substrate is overlapped with orthographic projections of n+1 multiplexing control lines in the second set of multiplexing control lines on the base substrate.

11. The display panel according to claim 10, wherein the plurality of sub-pixels comprise a first sub-pixel emitting light of a first color, a second sub-pixel emitting light of a second color, and a third sub-pixel emitting light of a third color; and
a multiplexing control line having an extension line in the second set of multiplexing control lines is configured to control the multiplexing circuit to provide a data signal to the third sub-pixel.

12. The display panel according to claim 11, wherein the N multiplexing control lines comprise a first multiplexing control line, a second multiplexing control line, a third multiplexing control line, a fourth multiplexing control line, a fifth multiplexing control line, a sixth multiplexing control line, a seventh multiplexing control line, an eighth multiplexing control line, and a ninth multiplexing control line;
the plurality of sub-pixels comprise a first set of sub-pixels, a second set of sub-pixels, and a third set of sub-pixels, wherein the first set of sub-pixels comprises a first set of first sub-pixels, a first set of second sub-pixels, and a first set of third sub-pixels, the second set of sub-pixels comprises a second set of first sub-pixels, a second set of second sub-pixels, and a second set of third sub-pixels, and the third set of sub-pixels comprises a third set of first sub-pixels, a third set of second sub-pixels, and a third set of third sub-pixels;
the first multiplexing control line is configured to control the multiplexing circuit to provide data signals to the first set of first sub-pixels;
the second multiplexing control line is configured to control the multiplexing circuit to provide data signals to the first set of second sub-pixels;
the third multiplexing control line is configured to control the multiplexing circuit to provide data signals to the first set of third sub-pixels;
the fourth multiplexing control line is configured to control the multiplexing circuit to provide data signals to the second set of first sub-pixels;
the fifth multiplexing control line is configured to control the multiplexing circuit to provide data signals to the second set of second sub-pixels;
the sixth multiplexing control line is configured to control the multiplexing circuit to provide data signals to the second set of third sub-pixels;
the seventh multiplexing control line is configured to control the multiplexing circuit to provide data signals to the third set of first sub-pixels;
the eighth multiplexing control line is configured to control the multiplexing circuit to provide data signals to the third set of second sub-pixels;
the ninth multiplexing control line is configured to control the multiplexing circuit to provide data signals to the third set of third sub-pixels;
the first set of multiplexing control lines comprises a sixth multiplexing control line, a seventh multiplexing control line, an eighth multiplexing control line, and a ninth multiplexing control line;
the second set of multiplexing control lines comprises a first multiplexing control line, a second multiplexing control line, a third multiplexing control line, a fourth multiplexing control line, and a fifth multiplexing control line; wherein the third multiplexing control line has an extension line.

13. The display panel according to claim 9, wherein an orthographic projection of each multiplexing data line of the first set of multiplexing data lines and the second set of multiplexing data lines on the base substrate is overlapped with orthographic projections of the N multiplexing control lines on the base substrate.

14. The display panel according to claim 13, wherein each of the N multiplexing control lines has an extension line; the N multiplexing control lines comprise a first set of multiplexing control lines and a second set of multiplexing control lines, wherein the first set of multiplexing control lines comprises n multiplexing control lines, and the second set of multiplexing control lines comprises n+1 multiplexing control lines;
an orthographic projection of each multiplexing data line in the first set of multiplexing data lines on the base substrate is overlapped with orthographic projections of extension lines of n multiplexing control lines in the first set of multiplexing control lines and n+1 multiplexing control lines in the second set of multiplexing control lines on the base substrate, and an orthographic projection of each multiplexing data line in the second set of multiplexing data lines on the base substrate is overlapped with orthographic projections of extension lines of n+1 multiplexing control lines in the second set of multiplexing control lines and n multiplexing control lines in the first set of multiplexing control lines on the base substrate.

15. The display panel according to any one of claims 3 to 8, 11, and 12, wherein the light of the first color is red light, the light of the second color is green light, and the light of the third color is blue light.

16. The display panel according to any one of claims 1 to 12 and 14, wherein the first bezel region comprises at least a first signal access region and a second signal access region, and the second signal access region is located on a side of the first signal access region away from the display region; the first signal access region is provided with a first set of first contact pads; the second signal access region is provided with a plurality of multiplexing control contact pads; and the plurality of multiplexing data lines are connected with a first set of first contact pads in the first signal access region, and the N multiplexing control lines are connected with a plurality of multiplexing control contact pads in the second signal access region.

17. The display panel according to claim 16, wherein the first signal access region is further provided with a second set of first contact pads, and the second set of first contact pads is located on a side of the first set of first contact pads away from the display region; the second signal access region is further provided with a set of middle contact pads; and a second set of first contact pads in the first signal access region is connected with the set of middle contact pads in the second signal access region through a plurality of pin connection lines; and
the plurality of multiplexing control contact pads in the second signal access region comprise a first set of multiplexing control contact pads and a second set of multiplexing control contact pads, and the first set of multiplexing control contact pads and the second set of multiplexing control contact pads are located on opposite sides of the set of middle contact pads along a first direction.

18. The display panel according to claim 17, wherein the first set of multiplexing control lines is connected with the first set of multiplexing control contact pads, and the second set of multiplexing control lines is connected with the second set of multiplexing control contact pads.

19. The display panel according to claim 17, wherein a first end of each multiplexing control line in the N multiplexing control lines is connected with the first set of multiplexing control contact pads, and a second end of each multiplexing control line is connected with the second set of multiplexing control contact pads.

20. The display panel according to claim 1, wherein orthographic projections of the plurality of multiplexing data lines on the base substrate are not overlapped with orthographic projections of the N multiplexing control lines on the base substrate, and the N multiplexing control lines comprise a first set of multiplexing control lines and a second set of multiplexing control lines, wherein the first set of multiplexing control lines comprises n multiplexing control lines and the second set of multiplexing control lines comprises n+1 multiplexing control lines; and the first set of multiplexing control lines and the second set of multiplexing control lines are disposed on opposite sides of the plurality of multiplexing data lines.

21. A display apparatus, comprising a display panel according to any one of claims 1 to 20.

22. A display panel, comprising:
a base substrate, comprising a display region and a first bezel region located on at least one side of the display region;
a plurality of sub-pixels and a plurality of data lines located in the display region, wherein the plurality of data lines are connected with the plurality of sub-pixels and configured to provide data signals to the plurality of sub-pixels; and
a plurality of multiplexing circuits, a plurality of multiplexing data lines, and N multiplexing control lines which are located in the first bezel region, wherein N is equal to 2n+1, and n is an integer greater than 0;
wherein at least one multiplexing circuit of the plurality of multiplexing circuits is electrically connected with the N multiplexing control lines, one multiplexing data line, and a plurality of data lines, and is configured to provide a data signal transmitted by the multiplexing data line to the plurality of data lines under control of the N multiplexing control lines;
at least part of line segments of each multiplexing data line of the plurality of multiplexing data lines extend along a first direction and at least part of line segments of each multiplexing control line of the N multiplexing control lines extend along a second direction; and at least part of line segments of the multiplexing data line intersect with at least part of line segments of the multiplexing control line.

23. The display panel according claim 22, wherein at least part of line segments of the multiplexing control line and at least part of line segments of the plurality of multiplexing data lines have a same intersection angle.

24. The display panel according to claim 22, wherein an intersection angle between at least part of line segments of the multiplexing control line and at least part of line segments of the multiplexing data line is less than or equal to 90 degrees.

25. The display panel according to claim 22, wherein a value of N is 9.
